# EUROPEAN PATENT APPLICATION

(11) **EP 4 819 783 A1**
(43) Date of publication of application: **07.10.2026**
(21) Application number: 24897309.1
(22) Date of filing: 14.11.2024
(51) Int. Cl.: H05K 9/00, B32B 15/08, H01F 1/26

(54) **ELECTROMAGNETIC WAVE SHIELDING MATERIAL, ELECTRONIC COMPONENT, AND ELECTRONIC DEVICE**

(30) Priority: 30.11.2023 JP 2023203288; 03.07.2024 JP 2024107467
(71) Applicant: FUJIFILM Corporation, Tokyo 106-8620 (JP)
(72) Inventor: MIKAMI Tatsuo, Minamiashigara-shi, Kanagawa 250-0193 (JP); IMAI Takashi, Minamiashigara-shi, Kanagawa 250-0193 (JP); FUKAGAWA Kiyotaka, Minamiashigara-shi, Kanagawa 250-0193 (JP); SUZUKI Ryota, Minamiashigara-shi, Kanagawa 250-0193 (JP)
(74) Representative: HGF
(86) International application number: PCT/JP2024/040421
(87) International publication number: WO 2025/115622

(57) **Abstract**

Provided are an electromagnetic wave shielding material including one or more magnetic layers sandwiched between two metal layers, and resin-containing layers on both sides of at least one metal layer of the two metal layers, in which a difference in thickness between the resin-containing layers on both sides of the metal layer is 20 µm or less, and an electronic component and an electronic apparatus which include the electromagnetic wave shielding material.

## Description

### Technical Field

The present invention relates to an electromagnetic wave shielding material, an electronic component, and an electronic apparatus.

### Background Art

In recent years, an electromagnetic wave shielding material has attracted attention as a material for reducing an influence of an electromagnetic wave in various electronic components and various electronic apparatuses (see, for example, PTL 1). The electromagnetic wave shielding material is capable of exhibiting performance of shielding electromagnetic waves (hereinafter, also referred to as a "shielding ability") by reflecting electromagnetic waves incident on the electromagnetic wave shielding material by the electromagnetic wave shielding material and/or by attenuating the electromagnetic waves inside the electromagnetic wave shielding material.

### Citation List

### Patent Literature

PTL 1: WO2022/255022A1

### Summary of Invention

### Technical Problem

PTL 1 discloses the electromagnetic wave shielding material having one or more magnetic layers sandwiched between two metal layers. A fact that the electromagnetic wave shielding material has a multilayer structure in which the magnetic layer is sandwiched between the two metal layers in this way can contribute to the electromagnetic wave shielding material being capable of exhibiting a high shielding ability (see paragraph 0025 of PTL 1).

The electromagnetic wave shielding material can be exposed to a temperature change in a state of being incorporated into an electronic component or an electronic apparatus. Therefore, it is desired that the electromagnetic wave shielding material has excellent durability after being exposed to a temperature change.

In view of the above circumstances, an object of an aspect of the present invention is to provide an electromagnetic wave shielding material which has one or more magnetic layers sandwiched between two metal layers and excellent durability after being exposed to a temperature change.

### Solution to Problem

One aspect of the present invention is as follows.
[1] An electromagnetic wave shielding material comprising: one or more magnetic layers sandwiched between two metal layers; and resin-containing layers on both sides of at least one metal layer of the two metal layers, in which a difference in thickness between the resin-containing layers on both sides of the metal layer is 20 µm or less.
[2] The electromagnetic wave shielding material according to [1], in which a total thickness of the resin-containing layers on both sides of the metal layer is 30 µm or more.
[3] The electromagnetic wave shielding material according to [1] or [2], in which a total thickness of the resin-containing layers included in the electromagnetic wave shielding material is less than 100 µm.
[4] The electromagnetic wave shielding material according to any one of [1] to [3], in which at least one resin-containing layer of the resin-containing layers on both sides of the metal layer includes one or more flame-retardant layers.
[5] The electromagnetic wave shielding material according to any one of [2] to [4], in which the total thickness of the resin-containing layers included in the electromagnetic wave shielding material is less than 100 µm, and at least one resin-containing layer of the resin-containing layers on both sides of the metal layer includes one or more flame-retardant layers.
[6] The electromagnetic wave shielding material according to any one of [1] to [5], in which resin-containing layers are provided on both sides of each of the two metal layers.
[7] The electromagnetic wave shielding material according to [6], in which a difference in thickness of the resin-containing layers located on both sides of one metal layer of the two metal layers is 20 µm or less, and a difference in thickness of the resin-containing layers located on both sides of the other metal layer is 20 µm or less.
[8] The electromagnetic wave shielding material according to [6] or [7], in which a total thickness of the resin-containing layers located on both sides of one metal layer of the two metal layers is 30 µm or more, and a total thickness of the resin-containing layers located on both sides of the other metal layer is 30 µm or more.
[9] The electromagnetic wave shielding material according to any one of [6] to [8], in which a total thickness of the resin-containing layers included in the electromagnetic wave shielding material is less than 100 µm.
[10] The electromagnetic wave shielding material according to any one of [6] to [9], in which at least one of the resin-containing layers includes one or more flame-retardant layers.
[11] The electromagnetic wave shielding material according to any one of [7] to [10], in which a total thickness of the resin-containing layers located on both sides of one metal layer of the two metal layers is 30 µm or more, and a total thickness of the resin-containing layers located on both sides of the other metal layer is 30 µm or more, a total thickness of the resin-containing layers included in the electromagnetic wave shielding material is less than 100 µm, and at least one of the resin-containing layers includes one or more flame-retardant layers.
[12] The electromagnetic wave shielding material according to any one of [1] to [11], in which the magnetic layer contains a urethane resin, and a resin having a partial structure represented by Formula 1: 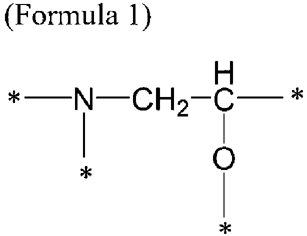 (in Formula 1, * represents a bonding position to an adjacent atom).
[13] The electromagnetic wave shielding material according to any one of [1] to [12], in which the magnetic layer contains a urethane resin, and a resin having one or more partial structures selected from the group consisting of a partial structure represented by Formula 1-1, a partial structure represented by Formula 1-2, and a partial structure represented by Formula 1-3: 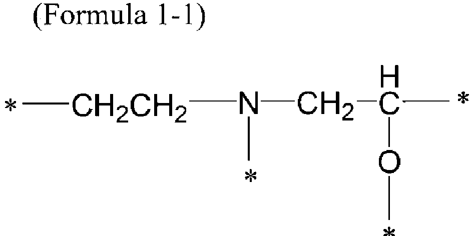 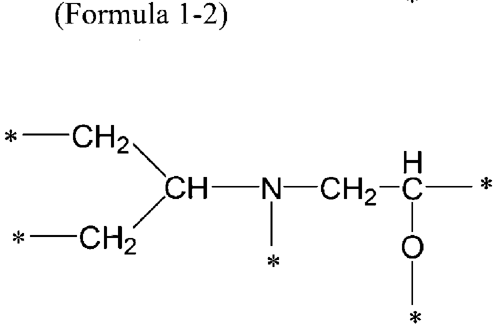 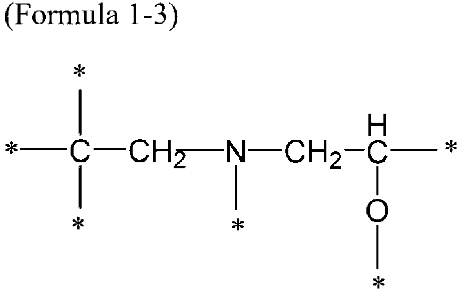 (in Formula 1-1, Formula 1-2, and Formula 1-3, * represents a bonding position to an adjacent atom).
[14] An electromagnetic wave shielding material comprising: a magnetic layer that contains a urethane resin and a resin having a partial structure represented by Formula 1: 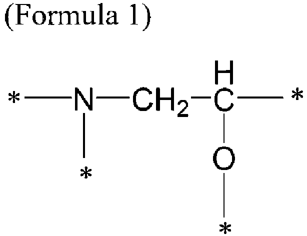 (in Formula 1, * represents a bonding position to an adjacent atom).
[15] An electromagnetic wave shielding material comprising: a magnetic layer that contains a urethane resin and a resin having one or more partial structures selected from the group consisting of a partial structure represented by Formula 1-1, a partial structure represented by Formula 1-2, and a partial structure represented by Formula 1-3: 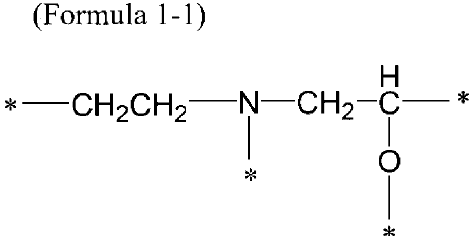 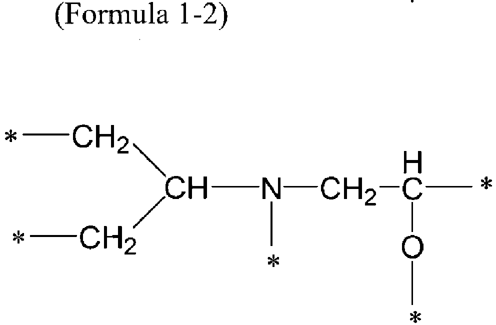 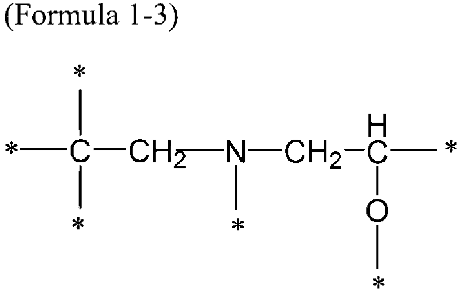 (in Formula 1-1, Formula 1-2, and Formula 1-3, * represents a bonding position to an adjacent atom).
[16] The electromagnetic wave shielding material according to [14] or [15], in which the electromagnetic wave shielding material has the magnetic layer between two resin-containing layers.
[17] An electronic component comprising: the electromagnetic wave shielding material according to any one of [1] to [16].
[18] An electronic apparatus comprising: the electromagnetic wave shielding material according to any one of [1] to [16].

### Effects of Invention

According to the aspect of the present invention, it is possible to provide an electromagnetic wave shielding material which has one or more magnetic layers sandwiched between two metal layers and excellent durability after being exposed to a temperature change. In addition, according to the aspect of the present invention, it is possible to provide an electronic component and an electronic apparatus, which include the electromagnetic wave shielding material.

### Description of Embodiments

### [Electromagnetic wave shielding material]

One aspect of the present invention relates to an electromagnetic wave shielding material. The electromagnetic wave shielding material comprises one or more magnetic layers sandwiched between two metal layers, and resin-containing layers on both sides of at least one metal layer of the two metal layers, in which a difference in thickness between the resin-containing layers on both sides of the metal layer is 20 µm or less.

In the present invention and the present specification, the "electromagnetic wave shielding material" shall refer to a material that is capable of exhibiting shielding ability against an electromagnetic wave of at least one frequency or at least a part of a range of a frequency band. The "electromagnetic wave" includes a magnetic field wave and an electric field wave. The "electromagnetic wave shielding material" can be a material that is capable of exhibiting shielding ability against one or both of a magnetic field wave of at least one frequency or at least a part of a range of a frequency band and an electric field wave of at least one frequency or at least a part of a range of a frequency band.

In the present invention and the present specification, "magnetic" means having a ferromagnetic property.

In the present invention and the present specification, the thickness of each layer included in the electromagnetic wave shielding material shall be determined by imaging a cross section exposed by a known method with a scanning electron microscope (SEM) and determining an arithmetic average of thicknesses of five randomly selected points in the obtained SEM image.

The electromagnetic wave shielding material has one or more magnetic layers sandwiched between two metal layers. As described above, the fact that the electromagnetic wave shielding material has a multilayer structure in which the magnetic layer is sandwiched between the two metal layers in this way can contribute to the electromagnetic wave shielding material being capable of exhibiting a high shielding ability.

Furthermore, the present inventor considers that the electromagnetic wave shielding material further having resin-containing layers on both sides of at least one metal layer of the two metal layers contributes to improvement of the elongation property of the electromagnetic wave shielding material. The electromagnetic wave shielding material having an excellent elongation property is preferable from the viewpoint of, for example, easy shape forming during forming. Meanwhile, the resin-containing layer tends to contract and/or expand in a case of being subjected to a temperature change. The present inventor considers that this point may cause peeling to occur at an interface between the magnetic layer and the adjacent layer and/or in the magnetic layer after the electromagnetic wave shielding material comprising one or more magnetic layers sandwiched between two metal layers and resin-containing layers on both sides of at least one metal layer of the two metal layers is exposed to a temperature change.

On the other hand, the present inventor considers that the fact that the difference in thickness between the resin-containing layers on both sides of the metal layer in the electromagnetic wave shielding material is 20 µm or less contributes to suppression of occurrence of stress in the electromagnetic wave shielding material due to contraction and/or expansion of the resin-containing layers, and as a result, it is possible to suppress the occurrence of the above-described peeling.

However, the present invention is not limited by supposition of the present inventor described in the present specification.

Hereinafter, the electromagnetic wave shielding material will be described in more detail.

### <Magnetic Layer>

### (Magnetic material)

The magnetic layer is a layer containing a magnetic material. Examples of the magnetic material include magnetic particles. As the magnetic particles, one kind selected from the group consisting of magnetic particles generally called soft magnetic particles, such as metal particles and ferrite particles, can be used, or two or more kinds therefrom can be used in combination at any ratio. Since the metal particles generally have a saturation magnetic flux density of about 2 to 3 times as compared with ferrite particles, the metal particles can maintain specific magnetic permeability and exhibit shielding ability even under a strong magnetic field without magnetic saturation. Therefore, the magnetic particles to be contained in the magnetic layer are preferably metal particles. In the present invention and the present specification, a layer containing metal particles **as** the magnetic material shall correspond to the "magnetic layer".

The magnetic particles can be particles having any shape such as a spherical shape, a needle shape, and a flat shape. The flat-shaped particles are preferable from the viewpoint of improving the shielding ability of the electromagnetic wave shielding material since high magnetic permeability can be obtained due to a small demagnetic field in the in-plane direction of the particles. In the present invention and the present specification, the "flat-shaped particle" refers to a particle having an aspect ratio of 0.20 or less. For the flat-shaped particles and the aspect ratio, paragraphs 0031 to 0033 of WO2022/255022A1 can be referred to.

### Metal particles

Examples of the metal particles as the magnetic material include particles of Sendust (an Fe-Si-Al alloy), a permalloy (an Fe-Ni alloy), a molybdenum permalloy (an Fe-Ni-Mo alloy), a Fe-Si alloy, a Fe-Cr alloy, an Fe-containing alloy generally called the iron-based amorphous alloy, a Co-containing alloy generally called the cobalt-based amorphous alloy, an alloy generally called the nanocrystal alloy, iron, Permendur (an Fe-Co alloy). Among them, Sendust is preferable since it exhibits a high saturation magnetic flux density and a high specific magnetic permeability. The metal particles may contain, in addition to the constitutional element of the metal (including the alloy), elements contained in an additive that can be optionally added and/or elements contained in impurities that can be unintentionally mixed in a manufacturing process of the metal particles at any content rate. In the metal particles, the content of the constitutional element of the metal (including the alloy) is preferably 90.0% by mass or more and more preferably 95.0% by mass or more, and it may be 100% by mass or may be less than 100% by mass, 99.9% by mass or less, or 99.0% by mass or less.

The content of the magnetic particles in the magnetic layer is, for example, 50% by mass or more, 60% by mass or more, 70% by mass or more, and 80% by mass or more with respect to the total mass of the magnetic layer, and it can be, for example, 100% by mass or less, 98% by mass or less, or 95% by mass or less.

In one form, as the magnetic layer, a sintered body (a ferrite plate) of ferrite particles or the like can be used. Considering that, for example, there is a case where the electromagnetic wave shielding material is cut out to a desired size and there is a case where the electromagnetic wave shielding material is bent into a desired shape, the magnetic layer containing a resin is preferable as compared with a ferrite plate which is a sintered body.

### (Resin)

The magnetic layer can contain a resin, and it can contain a magnetic material (for example, magnetic particles) and a resin. In the present invention and the present specification, the "resin" means a polymer, and it shall include rubber and an elastomer as well. The polymer includes a homopolymer and a copolymer. The rubber includes natural rubber and synthetic rubber. The elastomer is a polymer that exhibits elastic deformation. In addition, in the magnetic layer, the same type or different types of resins may be crosslinked by a curing agent or the like. In the present invention and the present specification, a layer containing both magnetic material and a resin shall correspond to the "magnetic layer". In the magnetic layer containing the magnetic material and the resin, the content of the resin can be, for example, 1 part by mass or more, 3 parts by mass or more, or 5 parts by mass or more per 100 parts by mass of the magnetic material, and it can be 30 parts by mass or less or 25 parts by mass or less.

The resin can act as a binder in the magnetic layer. Examples of the resin to be contained in the magnetic layer include known thermoplastic resins in the related art, a thermosetting resin, an ultraviolet curable resin, a radiation curable resin, a rubber-based material, and an elastomer. Specific examples thereof include a polyester resin, a polyethylene resin, a polyvinyl chloride resin, a polyvinyl butyral resin, a polyurethane resin, a polyester urethane resin, a cellulose resin, an acrylic resin, an acrylonitrile-butadiene-styrene (ABS) resin, a nitrile-butadiene rubber, a styrene-butadiene rubber, an epoxy resin, a phenol resin, an amide resin, a silicone resin, a styrene-based elastomer, an olefin-based elastomer, a vinyl chloride-based elastomer, a polyester-based elastomer, a polyamide-based elastomer, a polyurethane-based elastomer, and an acrylic elastomer. In the present invention and the present specification, the term "urethane resin" is used as a generic term for a resin having a urethane bond.

In addition to the above-described components, the magnetic layer can also contain any amount of one or more known additives such as a curing agent, a curing accelerator, a dispersing agent, a stabilizer, and a crosslinking agent (for example, a coupling agent).

The curing agent can play a role of improving the strength and the durability in the magnetic layer. Examples of the curing agent contained in the magnetic layer include a thermosetting resin, a photocurable resin (for example, an ultraviolet curable resin, a radiation curable resin and the like), a moisture-curable resin and the like, a polymerization initiator, a reaction catalyst and the like. Specific examples thereof include isocyanate, polyol, an epoxy resin, an acid anhydride, polyamine, a phenol resin, an unsaturated polyester resin, a urea resin, and diallyl phthalate. A part or all of the curing agent may be present in the magnetic layer in a form after the curing reaction.

Examples of the isocyanate include an aliphatic polyisocyanate, an aromatic polyisocyanate, an aromatic-aliphatic polyisocyanate, and an alicyclic polyisocyanate. Specific examples of the aliphatic polyisocyanate include hexamethylene diisocyanate (HDI), a trimethylolpropane (TMP) adduct of HDI, a biuret of HDI, and an isocyanurate of HDI. Specific examples of the aromatic polyisocyanate include tolylene diisocyanate (TDI), an adduct of TDI and a polyol compound (for example, a TMP adduct of TDI), a biuret of TDI, and an isocyanurate of TDI. Specific examples of the aromatic-aliphatic polyisocyanate include xylylene diisocyanate (XDI), a TMP adduct of XDI, a biuret of XDI, and an isocyanurate of XDI. Specific examples of the alicyclic polyisocyanate include isophorone diisocyanate (IPDI), a TMP adduct of IPDI, a biuret of IPDI, and an isocyanurate of IPDI.

Examples of the epoxy resin include various epoxy resins, such as a bisphenol A epoxy resin, a bisphenol F epoxy resin, a bisphenol S epoxy resin, a bisphenol AF epoxy resin, a dicyclopentadiene epoxy resin, a trisphenol epoxy resin, a naphthol novolak epoxy resin, a phenol novolak epoxy resin, a tert-butyl-catechol epoxy resin, a naphthalene epoxy resin, a naphthol epoxy resin, an anthracene epoxy resin, a glycidylamine epoxy resin, a glycidyl ester epoxy resin, a cresol novolak epoxy resin, a biphenyl epoxy resin, a linear aliphatic epoxy resin, an epoxy resin having a butadiene structure, an alicyclic epoxy resin, a heterocyclic epoxy resin, an epoxy resin containing a spiro ring, a cyclohexanedimethanol epoxy resin, a naphthylene ether epoxy resin, and a trimethylol epoxy resin. The epoxy resin may be used alone or in combination of two or more at an arbitrary proportion. A composition including an epoxy resin can be cured by opening a ring of an epoxy group included in the epoxy resin by heating to form a crosslinking structure. In the magnetic layer formed by curing the composition containing an epoxy resin, a part or all of the epoxy groups included in the epoxy resin can be included in a state in which the ring is opened to form a crosslinking structure.

Examples of the reaction catalyst include imidazoles, sulfonic acids, 1,8-diazabicyclo[5.4.0]-7-undecene (DBU) salts, amines, heavy metals, acids, and cyclic ethers.

For example, the magnetic layer formed of a composition for forming a magnetic layer, containing a urethane resin, an epoxy resin, and an isocyanate, can contain a urethane resin and a resin having a partial structure represented by Formula 1. In Formula 1, * represents a bonding position to an adjacent atom.

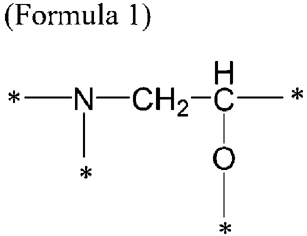

The partial structure represented by Formula 1 can be formed by a reaction between an amino group derived from an isocyanate group of the isocyanate (for example, an amino group generated by a reaction between an isocyanate group and H₂O) and an epoxy group of the epoxy resin. In the magnetic layer, the resin having a partial structure represented by Formula 1 and the urethane resin may or may not be crosslinked by a curing agent or the like. The same applies to the resin having one or more partial structures selected from the group consisting of a partial structure represented by Formula 1-1, a partial structure represented by Formula 1-2, and a partial structure represented by Formula 1-3, and a urethane resin.

In one form, the magnetic layer formed of a composition for forming a magnetic layer, containing a urethane resin, an epoxy resin, and an isocyanate, can contain a urethane resin and a resin having one or more partial structures selected from the group consisting of a partial structure represented by Formula 1-1, a partial structure represented by Formula 1-2, and a partial structure represented by Formula 1-3. In Formula 1-1, Formula 1-2, and Formula 1-3, * represents a bonding position to an adjacent atom. The partial structure represented by each of Formula 1-1, Formula 1-2, and Formula 1-3 includes the partial structure represented by Formula 1. In addition, in another form, the resin contained in the magnetic layer can be a resin having a partial structure represented by Formula 1, but not having a partial structure represented by Formula 1-1, a partial structure represented by Formula 1-2, and a partial structure represented by Formula 1-3.

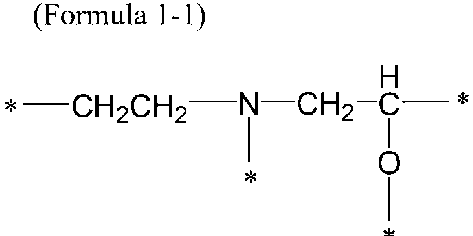

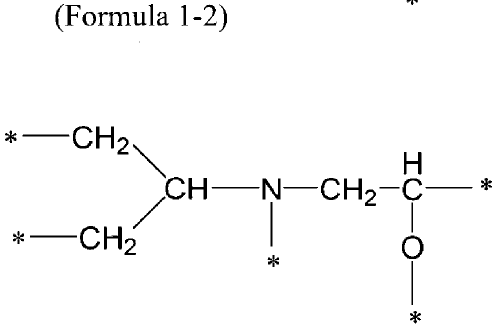

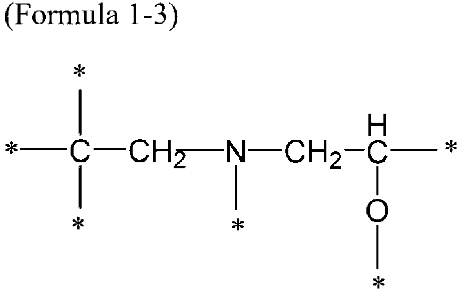

For example, the magnetic layer formed of a composition for forming a magnetic layer, containing a urethane resin, an epoxy resin, and HDI, can contain a urethane resin and a resin having a partial structure represented by Formula 1-1. The magnetic layer formed of a composition for forming a magnetic layer, containing a urethane resin, an epoxy resin, and IPDI, can contain a urethane resin and a resin having a partial structure represented by Formula 1-2 and/or a partial structure represented by Formula 1-3.

It is preferable that the magnetic layer contains a urethane resin and a resin having a partial structure represented by Formula 1, from the viewpoint of improving the adhesiveness between the magnetic layer and a layer adjacent to the magnetic layer, and from the viewpoint of improving the strength of the magnetic layer. From these viewpoints, it is more preferable that the magnetic layer contains a urethane resin and a resin having one or more partial structures selected from the group consisting of Formula 1-1, Formula 1-2, and Formula 1-3.

The fact that the urethane resin and the resin having the partial structure are contained in the magnetic layer can be confirmed by a known method.

In a case where the electromagnetic wave shielding material includes only one magnetic layer, the thickness of this one magnetic layer can be, for example, 5 µm or more, and it is preferably 10 µm or more and more preferably 20 µm or more from the viewpoint of further improving the shielding ability of the electromagnetic wave shielding material. Meanwhile, the thickness of this one magnetic layer can be, for example, 100 µm or less or 90 µm or less, and it is preferably less than 90 µm, more preferably 80 µm or less, and still more preferably 70 µm or less, from the viewpoint of improving forming workability.

In a case where the electromagnetic wave shielding material includes two or more magnetic layers, the thickness of each of the two or more magnetic layers (that is, the thickness per one layer) can be, for example, 5 µm or more, and it is preferably 10 µm or more and more preferably 20 µm or more from the viewpoint of further improving the shielding ability of the electromagnetic wave shielding material. Meanwhile, this one magnetic layer can be, for example, 100 µm or less or 90 µm or less, and it is preferably less than 90 µm and more preferably 80 µm or less, from the viewpoint of improving forming workability. The respective thicknesses of the two or more magnetic layers can be the same thickness or thicknesses different from each other.

In a case where the electromagnetic wave shielding material includes only one magnetic layer, this one magnetic layer is a magnetic layer sandwiched between two metal layers.
In a case where the electromagnetic wave shielding material includes two or more magnetic layers, at least one magnetic layer can be a magnetic layer sandwiched between the two metal layers, and some or all of the two or more magnetic layers can each also be a magnetic layer sandwiched between the two metal layers.

Specific examples of the layer configuration of such an electromagnetic wave shielding material will be described later.

### <Metal layer>

The electromagnetic wave shielding material has a multilayer structure in which the magnetic layer is sandwiched between two metal layers. The electromagnetic wave shielding material includes one or more such multilayer structures and can also include two or more such multilayer structures. That is, the electromagnetic wave shielding material includes at least two metal layers and can also include three or more metal layers, or it includes at least one magnetic layer and can also include two or more magnetic layers. The two or more layers of metal layer included in the electromagnetic wave shielding material have the same composition and thickness in one form and differ in composition and/or thickness in another form. The same applies to a case where the electromagnetic wave shielding material includes two or more magnetic layers, and the same applies to a case where two or more other layers such as a resin-containing layer described later are included in the electromagnetic wave shielding material.

In the present invention and the present specification, the "metal layer" shall refer to a layer containing a metal. The metal layer can be a layer containing one or more kinds of metals as a pure metal consisting of a single metal element, as an alloy of two or more kinds of metal elements, or as an alloy of one or more kinds of metal elements and one or more kinds of non-metal elements.

The metal layer included in the electromagnetic wave shielding material can be a layer that contains one or more kinds of metals selected from the group consisting of various pure metals and various alloys. The metal layer can exhibit an attenuation effect in the shielding material. This point is preferable from the viewpoint of improving the shielding ability of the electromagnetic wave shielding material. Since the attenuation effect increases as the propagation constant increases and the propagation constant increases as the electrical conductivity is higher, it is preferable that the metal layer contains a metal element having a high electrical conductivity. From this point, it is preferable that the metal layer contains, as a main component, a pure metal of Ag, Cu, Au, or Al, or an alloy containing any one of these. The pure metal is a metal consisting of a single metal element and may contain a trace amount of impurities. In general, a metal having a purity of 99.0% or more consisting of a single metal element is called a pure metal. The purity is based on mass. The alloy is generally prepared by adding one or more kinds of metal elements or non-metal elements to a pure metal to adjust the composition, for example, in order to prevent corrosion or improve the strength. The main component in the alloy is a component having the highest ratio on a mass basis, and it can be, for example, a component that occupies 80.0% by mass or more (for example, 99.8% by mass or less) in the alloy. From the viewpoint of economic efficiency, a pure metal of Cu or Al or an alloy containing Cu or Al as a main component is preferable.

In one form, the purity of the metal in the metal layer, that is, the content of the metal in the metal layer can be 99.0% by mass or more, 99.5% by mass or more, or 99.8% by mass or more with respect to the total mass of the metal layer. Unless otherwise specified, the content of metal in the metal layer shall refer to the content on a mass basis. For example, as the metal layer, a pure metal or an alloy processed into a sheet shape can be used. For example, as the metal layer, a commercially available metal foil or a metal foil produced by a known method can be used. Regarding a pure metal of Cu, sheets (so-called copper foils) having various thicknesses are commercially available. For example, such a copper foil can be used as the metal layer. The copper foil includes, according to manufacturing methods thereof, an electrolytic copper foil obtained by precipitating a copper foil on a cathode by electroplating and a rolled copper foil obtained by applying heat and pressure to an ingot and stretching the ingot thinly. Any copper foil can be used as the metal layer of the electromagnetic wave shielding material. In addition, for example, regarding Al, sheets (so-called aluminum foils) having various thicknesses are commercially available. For example, such an aluminum foil can be used as the metal layer.

From the viewpoint of reducing the weight of the electromagnetic wave shielding material, one or both (preferably both) of the two metal layers sandwiching the magnetic layer is preferably a metal layer containing the metal selected from the group consisting of Al and Mg, and more preferably a layer containing, as a main component, the metal selected from the group consisting of Al and Mg. The main component of the metal layer is a component having the highest ratio on a mass basis. In a layer containing, as a main component, a metal selected from the group consisting of Al and Mg, Al or Mg is a component having the highest ratio on a mass basis in this layer. Such a layer may contain only Al or Mg among Al and Mg, or may contain Al and Mg. A value (specific gravity/electrical conductivity) obtained by dividing the specific gravity by the electrical conductivity is small both in Al and Mg. As a metal in which this value is smaller is used, the weight of the electromagnetic wave shielding material that exhibits a high shielding ability can be further reduced. As a value calculated from the literature value, for example, a value (specific gravity/electrical conductivity) obtained by dividing the specific gravity by the electrical conductivity of each of Cu, Al, and Mg is as follows. Cu: 1.5 × 10⁻⁷ m/S, Al: 7.6 × 10⁻⁸ m/S, Mg: 7.6 × 10⁻⁸ m/S. From the above values, it can be said that Al and Mg are preferred metals from the viewpoint of reducing the weight of the electromagnetic wave shielding material. The metal layer containing a metal selected from the group consisting of Al and Mg can contain only one of Al and Mg in one form and can contain both in another form. From the viewpoint of reducing the weight of the electromagnetic wave shielding material, one or both (preferably both) of the two metal layers sandwiching the magnetic layer is preferably a metal layer in which the content of the metal selected from the group consisting of Al and Mg is 80.0% by mass or more, and still more preferably a metal layer in which the content of the metal selected from the group consisting of Al and Mg is 90.0% by mass or more. The metal layer containing at least Al among Al and Mg can be a metal layer in which the Al content is 80.0% by mass or more, and it can be a metal layer in which the Al content is 90.0% by mass or more. The metal layer containing at least Mg among Al and Mg can be a metal layer in which the Mg content is 80.0% by mass or more, and it can be a metal layer in which the Mg content is 90.0% by mass or more. The content of the metal selected from the group consisting of Al and Mg, the Al content, and the Mg content can be each, for example, 99.9% by mass or less. The content of the metal selected from the group consisting of Al and Mg, the Al content, and the Mg content are each the content with respect to the total mass of the metal layer.

From one or more viewpoints of the viewpoint of economic efficiency, the viewpoint of high electrical conductivity, and the viewpoint of reducing the weight of the electromagnetic wave shielding material, one or both (preferably both) of the two metal layers sandwiching the magnetic layer is preferably a metal layer containing the metal selected from the group consisting of Al, Mg, and Cu, and more preferably a layer containing, as a main component, the metal selected from the group consisting of Al, Mg, and Cu. In a layer containing, as a main component, a metal selected from the group consisting of Al, Mg, and Cu, Al, Mg, or Cu is a component having the highest ratio on a mass basis in this layer. Such a layer can contain only one kind of metal or two or three kinds of metals among Al, Mg, and Cu. From the one or more viewpoints, one or both (preferably both) of the two metal layers sandwiching the magnetic layer is preferably a metal layer in which the content of the metal selected from the group consisting of Al, Mg, and Cu is 80.0% by mass or more, and still more preferably a metal layer in which the content of the metal selected from the group consisting of Al, Mg, and Cu is 90.0% by mass or more. The metal layer containing at least Al among Al, Mg, and Cu can be a metal layer in which the Al content is 80.0% by mass or more, and it can be a metal layer in which the Al content is 90.0% by mass or more. The metal layer containing at least Mg among Al, Mg, and Cu can be a metal layer in which the Mg content is 80.0% by mass or more, and it can be a metal layer in which the Mg content is 90.0% by mass or more. The metal layer containing at least Cu among Al, Mg, and Cu can be a metal layer in which the Cu content is 80.0% by mass or more, and it can be a metal layer in which the Cu content is 90.0% by mass or more. The content of the metal selected from the group consisting of Al, Mg, and Cu, the Al content, the Mg content, and the Cu content can be each, for example, 99.9% by mass or less. The content of the metal selected from the group consisting of Al, Mg, and Cu, the Al content, the Mg content, and the Cu content are each the content with respect to the total mass of the metal layer.

From the viewpoint of further improving the processability of the metal layer and the shielding ability of the electromagnetic wave shielding material, the thickness of the metal layer in terms of the thickness per one layer is preferably 4 µm or more, more preferably 5 µm or more, and still more preferably 10 µm or more. On the other hand, from the viewpoint of the processability of the metal layer, the thickness of the metal layer in terms of the thickness per one layer is preferably 200 µm or less, more preferably 100 µm or less, and still more preferably 50 µm or less.

### <Resin-containing layer>

The electromagnetic wave shielding material comprises one or more magnetic layers sandwiched between two metal layers, and resin-containing layers on both sides of at least one metal layer of the two metal layers, in which a difference in thickness between the resin-containing layers on both sides of the metal layer is 20 µm or less.

In the present invention and the present specification, the "resin-containing layer" is a layer containing one or more resins. The resin-containing layer can have a monolayer structure in one form, and has a laminated structure of two or more resin-containing layers having different compositions and/or thicknesses in another form. The "thickness of the resin-containing layer" refers to a thickness of the laminated structure for the resin-containing layer of the laminated structure. The resin-containing layers located on both sides of the metal layer may have the same composition, layer configuration, and the like, or may have different compositions, layer configurations, and the like.

In the electromagnetic wave shielding material, in one form, the resin-containing layers are included on both sides of only one of the two metal layers sandwiching the magnetic layer. In such a form, a difference in thickness between the two resin-containing layers is 20 µm or less. The difference in thickness can also be, for example, 18 µm or less, 16 µm or less, 14 µm or less, 12 µm or less, or 10 µm or less. In addition, the difference in thickness can also be 0 µm or more, 1 µm or more, or 2 µm or more. In a case where the difference in thickness is 0 µm, the two resin-containing layers have the same thickness.

In another form, the resin-containing layers are included on both sides of each of one and the other of the two metal layers sandwiching the magnetic layer. It is preferable that the resin-containing layers are located on both sides of each of both of the two metal layers from the viewpoint of suppressing corrosion of the metal layer. In such a form, a difference in thickness between the resin-containing layers located on both sides of at least one metal layer is 20 µm or less, and can also be, for example, 18 µm or less, 16 µm or less, 14 µm or less, 12 µm or less, or 10 µm or less. A difference in thickness between the resin-containing layers located on both sides of the other metal layer is 20 µm or less or more than 20 µm, is preferably 20 µm or less, and can also be, for example, 18 µm or less, 16 µm or less, 14 µm or less, 12 µm or less, or 10 µm or less. In addition, the difference in thickness can also be 0 µm or more, 1 µm or more, or 2 µm or more.

A total thickness of the two resin-containing layers located on both sides of the metal layer can be, for example, 10 µm or more, and from the viewpoint of improving the elongation property of the electromagnetic wave shielding material, it is preferably 30 µm or more, and it is preferably 40 µm or more, 50 µm or more, 60 µm or more, and 70 µm or more in this order. The total thickness of the two resin-containing layers can be, for example, 150 µm or less, 140 µm or less, 120 µm or less, or less than 100 µm. In the electromagnetic wave shielding material, in a case where the resin-containing layers are included on both sides of each of one and the other of the two metal layers sandwiching the magnetic layer, a total thickness of the two resin-containing layers located on both sides of one metal layer is preferably within the above-described range, and a total thickness of the two resin-containing layers located on both sides of the other metal layer can be outside or within the above-described range, and is preferably within the above-described range.

A total thickness of the resin-containing layers included in the electromagnetic wave shielding material can be, for example, 180 µm or less, and from the viewpoint that a combustion time after the electromagnetic wave shielding material contacts with a flame is short, it is preferably less than 100 µm, more preferably 90 µm or less, and still more preferably 80 µm or less. The total thickness of the resin-containing layers included in the electromagnetic wave shielding material can be, for example, 10 µm or more, 15 µm or more, or 20 µm or more.

A thickness of one resin-containing layer included in the electromagnetic wave shielding material (in a case of a laminated structure, a thickness of the laminated structure) can be, for example, 1 µm or more and 60 µm or less. Note that it is not limited to the range exemplified here.

At least one, preferably both, of the resin-containing layers located on both sides of the metal layer can be a layer adjacent to the metal layer. In the present invention and the present specification, the term "adjacent" means being in direct contact without another layer interposed therebetween. In addition, the resin-containing layer adjacent to the metal layer can also be adjacent to the magnetic layer on a surface opposite to the surface adjacent to the metal layer. Specific examples of the layer configuration of the electromagnetic wave shielding material will be described later.

Hereinafter, specific forms of the resin-containing layer will be described.

### (Pressure-sensitive adhesive layer)

A pressure-sensitive adhesive layer can be mentioned as one form of the resin-containing layer. In the present invention and the present specification, the "pressure-sensitive adhesive layer" refers to a layer having tackiness on a surface at normal temperature. Regarding the tackiness, the "normal temperature" shall be defined as 23°C. In a case where such a layer comes into contact with an adherend, the layer adheres to the adherend due to the adhesive force thereof. In general, the tackiness is the property of exhibiting an adhesive force in a short time after coming into contact with an adherend with a very light force, and in the present invention and the present specification, the above-described "having tackiness" refers to that the result is No. 1 to No. 32 in a tilted ball tack test (measurement environment: a temperature of 23°C and a relative humidity of 50%) specified in JIS Z 0237: 2009. In a case where another layer is laminated on the surface of the pressure-sensitive adhesive layer, the surface of the pressure-sensitive adhesive layer exposed, for example, by peeling off the other layer can be subjected to the above-described test. In a case where another layer is laminated on each of one surface and the other surface of the pressure-sensitive adhesive layer, the layer on the side of either surface may be peeled off.

As the pressure-sensitive adhesive layer, it is possible to use those obtained by applying a composition for forming a pressure-sensitive adhesive layer containing a pressure sensitive adhesive such as an acrylic pressure sensitive adhesive, a rubber-based pressure sensitive adhesive, a silicone-based pressure sensitive adhesive, or a urethane-based pressure sensitive adhesive and processing it into a film shape.

The composition for forming a pressure-sensitive adhesive layer can be applied onto, for example, a support. The coating can be carried out using a known coating device such as a blade coater or a die coater. The coating can be carried out by a so-called roll-to-roll method or a batch method.

Examples of the support onto which the composition for forming a pressure-sensitive adhesive layer is applied include films of various resins such as polyester such as polyethylene terephthalate (PET) and polyethylene naphthalate (PEN), acryls such as polycarbonate (PC) and polymethyl methacrylate (PMMA), cyclic polyolefin, triacetyl cellulose (TAC), polyether sulfide (PES), polyether ketone, and polyimide. As the support, it is possible to use a support in which a surface (a surface to be coated) onto which the composition for forming a pressure-sensitive adhesive layer is applied is subjected to a peeling treatment according to a known method. One form of the peeling treatment includes forming a release layer. In addition, as the support, a commercially available peeled resin film can also be used. In a case of using a support in which the surface to be coated is subjected to the peeling treatment, it is possible to easily separate the pressure-sensitive adhesive layer and the support after the film formation.

By applying a composition for forming a pressure-sensitive adhesive layer, in which a pressure sensitive adhesive is dissolved and/or dispersed in a solvent, onto the surface to be coated and carrying out drying, a pressure-sensitive adhesive layer can be formed. Alternatively, a pressure sensitive adhesive tape including a pressure-sensitive adhesive layer can also be used. As the pressure sensitive adhesive tape, for example, it is possible to use a double-sided tape. The double-sided tape has pressure-sensitive adhesive layers on both surfaces of the support. In addition, as the pressure sensitive adhesive tape, it is possible to use a pressure sensitive adhesive tape having a pressure-sensitive adhesive layer on one surface of a support. Examples of the support include films of various resins such as polyester such as polyethylene terephthalate (PET) and polyethylene naphthalate (PEN), acryls such as polycarbonate (PC) and polymethyl methacrylate (PMMA), cyclic polyolefin, triacetyl cellulose (TAC), polyether sulfide (PES), polyether ketone, and polyimide, a nonwoven fabric, and paper. As the pressure sensitive adhesive tape having a pressure-sensitive adhesive layer on one surface or both surfaces of a support, it is possible to use a commercially available product, or it is possible to use a pressure sensitive adhesive tape produced by a known method.

The thickness of the pressure-sensitive adhesive layer is not particularly limited, and the thickness per layer can be, for example, 1 µm or more and 30 µm or less.

### (Adhesive layer)

An adhesive layer can be mentioned as one form of the resin-containing layer. In the present invention and the present specification, the "adhesive layer" is a layer in which a liquid or gel-like adhesive is solidified after coming into contact with an adherend and undergoing a state change such as drying or curing, at that time, adhesiveness to the adherend is exhibited by an anchoring effect, a physical interaction, or formation of a chemical bond to the adherend. In one form, the adhesive layer can be a layer having no tackiness on the surface at normal temperature. In addition, in one form, the adhesive layer can be adjacent to the magnetic layer or the metal layer, and can firmly closely attach the magnetic layer or the metal layer to the resin-containing layer.

The adhesive contains a resin that is solidified after being dried or cured. Examples of such a resin include a vinyl acetate resin, an ethylene vinyl acetate resin, an epoxy resin, a cyanoacrylate resin, an acrylic resin, a polyurethane resin, a chloroprene rubber, and a styrene butadiene rubber. These resins may be in the form of a liquid or a gel in the resin itself. Alternatively, the solid resin may be dissolved in a solvent to be in a liquid or gel form. Examples of the solvent contained in the adhesive include water, ketone-based solvents such as acetone, methyl ethyl ketone, and cyclohexanone, acetic acid ester-based solvents such as ethyl acetate, butyl acetate, cellosolve acetate, propylene glycol monomethyl ether acetate, and carbitol acetate, carbitols such as cellosolve and butyl carbitol, aromatic hydrocarbon-based solvents such as toluene and xylene, and amide-based solvents such as dimethylformamide, dimethylacetamide, and N-methylpyrrolidone, alcohol-based solvents such as ethanol, methanol, and propanol, and halogen-based solvents such as dichloromethane, trichloroethylene, and dichlorofluoroethane.

The adhesive may contain a monomer that forms a resin by a chemical reaction after contact with an adherend. Examples of such a monomer include an epoxy monomer, isocyanate, polyol, polyphenol, an acid anhydride, an acrylic acid ester, a methacrylic acid ester, a styrene monomer, and an allyl monomer. The monomer contains one or more functional groups that cause a chemical reaction. In a case where a monomer having three or more functional groups is used, a resin having a three-dimensional molecular structure is formed after the chemical reaction, and thus an adhesive layer having higher mechanical strength can be formed.

The thickness of the adhesive layer is not particularly limited, and the thickness per layer can be, for example, 1 µm or more and 30 µm or less.

### (Coating layer)

A coating layer can be mentioned as one form of the resin-containing layer. In the present invention and the present specification, the "coating layer" is a layer in which a liquid or gel-like coating agent is solidified after coming into contact with an adherend and undergoing a state change such as drying or curing, that exhibits water repellency, oil repellency, chemical resistance, abrasion resistance, or the like, and that contributes to suppression of aged deterioration of the electromagnetic wave shielding material, such as hydrolysis of a resin contained in the magnetic layer and/or the resin-containing layer, physical damage such as abrasion, or the like. In one form, the coating layer can be provided on the outermost surface of the electromagnetic wave shielding material.

The coating agent contains a resin that is solidified after being dried or cured. Examples of such a resin include various resins such as a silicone resin, a fluororesin, a polyolefin resin, a polyacetal resin, an epoxy resin, an acrylic resin, a polyurethane resin, a polyamide resin, a polyimide resin, a polyester resin, a polyphenylene ether resin, a polyphenylene sulfide resin, a polyetherimide resin, and a polycarbonate resin. These resins may be in the form of a liquid or a gel in the resin itself. Alternatively, the solid resin may be dissolved in a solvent to be in a liquid or gel form. Examples of the solvent contained in the coating agent include water, ketone-based solvents such as acetone, methyl ethyl ketone, and cyclohexanone, acetic acid ester-based solvents such as ethyl acetate, butyl acetate, cellosolve acetate, propylene glycol monomethyl ether acetate, and carbitol acetate, carbitols such as cellosolve and butyl carbitol, aromatic hydrocarbon-based solvents such as toluene and xylene, and amide-based solvents such as dimethylformamide, dimethylacetamide, and N-methylpyrrolidone, alcohol-based solvents such as ethanol, methanol, and propanol, and halogen-based solvents such as dichloromethane, trichloroethylene, and dichlorofluoroethane.

The thickness of the coating layer is not particularly limited, and the thickness per layer can be, for example, 1 µm or more and 10 µm or less.

The end part of the electromagnetic wave shielding material can also be covered with the coating agent. As a result, it is possible to suppress the invasion of moisture, oil, and chemicals from the end part, mechanical damage, and the like.

### (Resin layer)

A resin layer can be mentioned as one form of the resin-containing layer. In the present invention and the present specification, the "resin layer" is a resin film obtained by forming a thermoplastic resin such as a synthetic resin into a film shape, and the resin film has a film-like structure by itself and does not have tackiness at normal temperature.

Examples of the thermoplastic resin contained in the resin film include various resins such as a polyethylene (PE) resin, a polypropylene (PP) resin, a polyvinyl chloride (PVC) resin, a polystyrene (PS) resin, a vinyl acetate resin, a polyurethane resin, a polyvinyl alcohol resin, an ethylene vinyl acetate resin, styrene butadiene rubber, acrylonitrile butadiene rubber, silicone rubber, an olefin-based elastomer (PP), a styrene-based elastomer, an acrylonitrile-butadiene-styrene (ABS) resin, polyethylene terephthalate (PET), a polyester resin such as polyethylene naphthalate (PEN), a polycarbonate (PC) resin, an acrylic resin such as polymethyl methacrylate (PMMA), cyclic polyolefin, and triacetyl cellulose (TAC).

The thickness of the resin layer can be, for example, 10 µm or more or 12 µm or more as the thickness per resin layer. In addition, the thickness of the resin layer is, for example, more preferably 250 µm or less, 200 µm or less, 150 µm or less, or 100 µm or less as the thickness per resin layer.

The resin-containing layer can consist of, for example, only one layer of an adhesive layer, a pressure-sensitive adhesive layer, or a resin layer.

The resin-containing layer having a laminated structure can include one or more adhesive layers and/or one or more pressure-sensitive adhesive layers, and can include one or more resin layers.

The resin layer can be bonded to, for example, a metal layer or a magnetic layer by interposing a pressure-sensitive adhesive layer or an adhesive layer. In addition, since the resin layer is a thermoplastic resin-containing layer, the resin layer has the property of being softened by heating and flows and follows minute protrusions and recessions on the surface of the adherend by being pressed against the adherend in a state of being heated, thereby capable of exhibiting an adhesive force due to the anchoring effect, and then it is cooled, whereby the adhered state can be maintained. Therefore, in one form, the resin layer and the other layer can be bonded to each other without interposing the pressure-sensitive adhesive layer or the adhesive layer.

In addition, as the resin-containing layer having a laminated structure, a commercially available product or a double-sided tape produced by a known method can also be used.

In the resin-containing layer having a laminated structure including a resin layer, the thickness of the resin layer (in a case of including a plurality of resin layers, the total thickness thereof) with respect to 100% of the thickness of the layer (that is, the laminated structure) can be, for example, 60% or more, 70% or more, or 80% or more, and can be, for example, 100% or less, 99% or less, 98% or less, or 97% or less. The resin layer may be, for example, the resin film described above.

In one form, the resin-containing layer can include one or more flame-retardant layer. In the present invention and the present specification, the "flame-retardant layer" refers to a layer corresponding to any one or more of the following.

A layer of a flame-retardant rating UL 94 V-0 or UL 94 V-1 in Underwriter's Laboratories Inc. (UL) 94 standard (Tests for Flammability of Plastic Materials for Parts in Devices and Appliances). In general, UL 94 V-0 is also called "V-0", and UL 94 V-1 is also called "V-1".

A layer of a flame-retardant rating VTM-0 or VTM-1 in UL 94 VTM test (vertical burn test for thin plastic films).

The above-described flame-retardant layer is preferable from the viewpoint of a short combustion time after contact with a flame. With the resin-containing layer including such a layer, it is possible to shorten the combustion time after the electromagnetic wave shielding material contacts with a flame. The resin-containing layer can consist of only a flame-retardant layer, or can be a laminated structure including one or more flame-retardant layers. In the resin-containing layer having a laminated structure including a flame-retardant layer, the thickness of the flame-retardant layer (in a case of including a plurality of flame-retardant layers, the total thickness thereof) with respect to 100% of the thickness of the layer (that is, the laminated structure) can be, for example, 60% or more, 70% or more, or 80% or more, and can be, for example, 100% or less, 99% or less, 98% or less, or 97% or less.

### <Specific example of layer configuration>

The total number of layers of the magnetic layers included in the electromagnetic wave shielding material is such that, for example, one to four layers can be included. The electromagnetic wave shielding material includes one or more magnetic layers sandwiched between the two metal layers, and can also include two or more such magnetic layers. In addition, four or fewer layers of such magnetic layers can also be included.

In a case where the electromagnetic wave shielding material includes only one magnetic layer, this one magnetic layer is a magnetic layer sandwiched between the two metal layers.

In a case where the electromagnetic wave shielding material includes two or more magnetic layers, at least one layer of these two or more magnetic layers is a magnetic layer sandwiched between the two metal layers. Specifically, all or only a part of the magnetic layers included in the electromagnetic wave shielding material is a magnetic layer sandwiched between the two metal layers.

The electromagnetic wave shielding material comprises one or more magnetic layers sandwiched between two metal layers, and resin-containing layers on both sides of at least one metal layer of the two metal layers. Therefore, the resin-containing layer included in the electromagnetic wave shielding material is at least two layers. The number of resin-containing layers included in the electromagnetic wave shielding material can be, for example, 10 or less, 8 or less, 6 or less, or 4 or less.

Examples of the disposition of the "magnetic layer", the "metal layer", and the "resin-containing layer" in the electromagnetic wave shielding material include the following examples. However, the layer configuration of the electromagnetic wave shielding material is not limited to the layer configuration exemplified below. In the following, the symbol "/" means that the layer described on the left side of this symbol and the layer described on the right side of this symbol are in direct contact with each other (that is, adjacent to each other) without another layer being interposed therebetween.
Example 1: resin-containing layer 1/metal layer 1/resin-containing layer 2/magnetic layer 1/resin-containing layer 3/metal layer 2/resin-containing layer 4
Example 2: resin-containing layer 1/metal layer 1/resin-containing layer 2/magnetic layer 1/resin-containing layer 3/metal layer 2
Example 3: magnetic layer 1/resin-containing layer 1/metal layer 1/resin-containing layer 2/magnetic layer 2/resin-containing layer 3/metal layer 2/resin-containing layer 4/magnetic layer 3
Example 4: resin-containing layer 1/metal layer 1/resin-containing layer 2/magnetic layer 1/resin-containing layer 3/metal layer 2/resin-containing layer 4/magnetic layer 2/resin-containing layer 5/metal layer 3/resin-containing layer 6

For example, in Example 1, the resin-containing layers located on both sides of the metal layer 1 are the resin-containing layer 1 and the resin-containing layer 2. The magnetic layer 1 is a magnetic layer sandwiched between the metal layer 1 and the metal layer 2. The resin-containing layers located on both sides of the metal layer 2 are the resin-containing layer 3 and the resin-containing layer 4.

In Example 2, the resin-containing layers located on both sides of the metal layer 1 are the resin-containing layer 1 and the resin-containing layer 2. The magnetic layer 1 is a magnetic layer sandwiched between the metal layer 1 and the metal layer 2.

In Example 3, the resin-containing layers located on both sides of the metal layer 1 are the resin-containing layer 1 and the resin-containing layer 2. The magnetic layer 2 is a magnetic layer sandwiched between the metal layer 1 and the metal layer 2. The resin-containing layers located on both sides of the metal layer 2 are the resin-containing layer 3 and the resin-containing layer 4.

In Example 4, the resin-containing layers located on both sides of the metal layer 1 are the resin-containing layer 1 and the resin-containing layer 2. The magnetic layer 1 is a magnetic layer sandwiched between the metal layer 1 and the metal layer 2. The resin-containing layers located on both sides of the metal layer 2 are the resin-containing layer 3 and the resin-containing layer 4. The magnetic layer 2 is a magnetic layer sandwiched between the metal layer 2 and the metal layer 3. In Example 4, the metal layer 2 is one of the two metal layers that sandwich the magnetic layer 1, and it is also one of the two metal layers that sandwich the magnetic layer 2. For example, as in Example 4, metal layers that sandwich a certain magnetic layer can be metal layers that sandwich another magnetic layer.

In one form, one or both of the outermost layers of the electromagnetic wave shielding material can be a resin-containing layer. It is preferable that one or both of the outermost layers of the electromagnetic wave shielding material is a resin-containing layer from the viewpoint of suppressing corrosion of the outermost layer of the electromagnetic wave shielding material.

### <Manufacturing method for electromagnetic wave shielding material>

### (Film forming method for magnetic layer)

The magnetic layer can be produced, for example, by drying a coating layer that is provided by applying a composition for forming a magnetic layer. The composition for forming a magnetic layer can contain the components described above and can optionally contain one or more kinds of solvents. Examples of the solvent include various organic solvents, for example, ketone-based solvents such as acetone, methyl ethyl ketone, and cyclohexanone, acetic acid ester-based solvents such as ethyl acetate, butyl acetate, cellosolve acetate, propylene glycol monomethyl ether acetate, and carbitol acetate, carbitols such as cellosolve and butyl carbitol, aromatic hydrocarbon-based solvents such as toluene and xylene, and amide-based solvents such as dimethylformamide, dimethylacetamide, and N-methylpyrrolidone. One kind of solvent or two or more kinds of solvents selected in consideration of the solubility of the component that is used in the preparation of the composition for forming a magnetic layer can be mixed at any ratio and used. The solvent content of the composition for forming a magnetic layer is not particularly limited and may be determined in consideration of the coatability of the composition for forming a magnetic layer.

The composition for forming a magnetic layer can be prepared by sequentially mixing various components in any order or simultaneously mixing them. In addition, as necessary, a dispersion treatment can be carried out using a known dispersing machine such as a ball mill, a bead mill, a sand mill, or a roll mill, and/or a stirring treatment can be also carried out using a known stirrer such as a shaking type stirrer.

The composition for forming a magnetic layer can be applied onto, for example, a support. The coating can be carried out using a known coating device such as a blade coater or a die coater. The coating can be carried out by a so-called roll-to-roll method or a batch method.

Examples of the support onto which the composition for forming a magnetic layer is applied include films of various resins such as polyester such as polyethylene terephthalate (PET) and polyethylene naphthalate (PEN), acryls such as polycarbonate (PC) and polymethyl methacrylate (PMMA), cyclic polyolefin, triacetyl cellulose (TAC), polyether sulfide (PES), polyether ketone, and polyimide. For these resin films, reference can be made to paragraphs 0081 to 0086 of JP2015-187260A. As the support, it is possible to use a support in which a surface (a surface to be coated) onto which the composition for forming a magnetic layer is applied is subjected to a peeling treatment according to a known method. One form of the peeling treatment includes forming a release layer. For the release layer, reference can be made to paragraph 0084 of JP2015-187260A. In addition, as the support, a commercially available peeled resin film can also be used. In a case of using a support in which the surface to be coated is subjected to the peeling treatment, it is possible to easily separate the magnetic layer and the support after the film formation.

In addition, the composition for forming a magnetic layer can also be applied to the surface of the metal layer, the resin-containing layer, and the like. For example, a partial structure of the electromagnetic wave shielding material can also be produced by applying the composition for forming a magnetic layer to the surface of the metal layer or the resin-containing layer and, as necessary, subjecting the magnetic layer to a pressurization treatment described later. For example, a partial structure of "resin-containing layer/metal layer/resin-containing layer/magnetic layer" is produced by applying a coating liquid for forming a magnetic layer onto a surface of a resin-containing layer of a laminate having a layer configuration of "resin-containing layer/metal layer/resin-containing layer" and, as necessary, subjecting the magnetic layer to a pressurization treatment described later. Two partial structures of "resin-containing layer/metal layer/resin-containing layer/magnetic layer" produced in this way are crimped to each other with the magnetic layer sides facing each other by applying pressure and heat, thereby producing an electromagnetic wave shielding material having the layer configuration of the above-described Example 1 "resin-containing layer 1/metal layer 1/resin-containing layer 2/magnetic layer 1/resin-containing layer 3/metal layer 2/resin-containing layer 4".

A coating layer formed by applying the composition for forming a magnetic layer can be subjected to a drying treatment according to a known method such as heating or warm air blowing. The drying treatment can be carried out, for example, under conditions in which the solvent contained in the composition for forming a magnetic layer can be volatilized. As an example, the drying treatment can be carried out for 1 minute to 2 hours in a heated atmosphere having an atmospheric temperature of 80°C to 150°C.

### (Pressurization treatment of magnetic layer)

The magnetic layer can also be subjected to a pressurization treatment after film formation. In a case of subjecting the magnetic layer containing the magnetic particles to a pressurization treatment, it is possible to increase the density of the magnetic particles in the magnetic layer.

The pressurization treatment can be carried out by applying pressure in the thickness direction of the magnetic layer using a flat plate pressing machine, a roll pressing machine, or the like. In the flat plate pressing machine, an object to be pressurized is disposed between two flat press plates that are disposed vertically, and the two press plates are put together by mechanical or hydraulic pressure to apply pressure to the object to be pressurized. In the roll pressing machine, an object to be pressurized is allowed to pass between the rotating pressurization rolls that are disposed vertically, and at that time, mechanical or hydraulic pressure is applied to the pressurization rolls, or the distance between the pressurization rolls is made to be smaller than the thickness of the object to be pressurized, whereby the pressure can be applied.

The pressure during the pressurization treatment can be set freely. For example, in a case of a flat plate pressing machine, it is, for example, 1 to 50 newtons (N)/mm². In a case of a roll pressing machine, it is, for example, 20 to 400 N/mm in terms of the linear pressure.

The pressurization time can be set freely. It takes, for example, 5 seconds to 30 minutes in a case where a flat plate pressing machine is used. In a case where a roll pressing machine is used, the pressurization time can be controlled by the transport speed of the object to be pressurized, where the transport speed is, for example, 10 cm/min to 200 m/min.

The materials of the press plate and the pressurization roll can be randomly selected from metal, ceramics, plastic, and rubber.

In the pressurization treatment, it is also possible to carry out a pressurization treatment by applying a temperature to both of upper and lower press plates of a plate-shape pressing machine or one press plate thereof, or one roll of upper and lower rolls of a roll pressing machine. The magnetic layer can be softened by heating, which makes it possible to obtain a high compression effect in a case where pressure is applied. The temperature at the time of heating can be set freely, and it is, for example, 50°C or higher and 200°C or lower. The temperature at the time of heating can be the internal temperature of the press plate or the roll. Such a temperature can be measured with a thermometer installed inside the press plate or the roll.

After the heating and pressurization treatment with the plate-shape pressing machine, the press plates can be spaced apart from each other, for example, in a state where the temperature of the press plates is high, whereby the magnetic layer can be taken out. Alternatively, the press plate can be cooled by a method such as water cooling or air cooling while maintaining the pressure, and then the press plates can be spaced apart to take out the magnetic layer.

In the roll pressing machine, the magnetic layer can be cooled immediately after pressing, by a method such as water cooling or air cooling.

It is also possible to repeat the pressurization treatment two or more times.

In a case where the magnetic layer is formed into a film on a release film, it is possible to carry out a pressurization treatment, for example, in a state where the magnetic layer is laminated on the release film. Alternatively, the magnetic layer can also be peeled off from the release film and can be subjected to a pressurization treatment as a single layer of the magnetic layer.

### (Bonding of various layers)

A pressure-sensitive adhesive layer or an adhesive layer can be used for bonding various layers. The pressure-sensitive adhesive layer and the adhesive layer are as described above.

In addition, in the electromagnetic wave shielding material, two layers adjacent to each other can be also adhered to each other, for example, by applying pressure and heat to carry out crimping. A plate-shape pressing machine, a roll pressing machine, or the like can be used for the crimping. For example, in a case where the magnetic layer is disposed as a layer that is in direct contact with (that is, adjacent to) the adjacent layer, the magnetic layer is softened in a crimping step, and the contact with the surface of the adjacent layer is promoted, whereby the magnetic layer and the adjacent layer can be bonded to each other without interposing another layer. The pressure at the time of crimping can be set freely. In a case of a plate-shape pressing machine, it is, for example, 1 to 50 newtons (N)/mm². In a case of a roll pressing machine, it is, for example, 20 to 400 N/mm in terms of the linear pressure. The pressurization time at the time of crimping can be set freely. It takes, for example, 5 seconds to 30 minutes in a case where a plate-shape pressing machine is used. In a case where a roll pressing machine is used, the pressurization time can be controlled by a transport speed of an object to be pressurized, and the transport speed is, for example, 10 cm/min to 200 m/min. The temperature at the time of crimping can be selected freely, and it is, for example, 20°C or higher and 200°C or lower. The temperature during the above-described crimping can be, for example, an internal temperature of a press plate or a roll.

The electromagnetic wave shielding material can be incorporated into, in any shape, an electronic component or an electronic apparatus. The electromagnetic wave shielding material can have a sheet shape, where the size thereof is not particularly limited. In the present invention and the present specification, the "sheet" has the same meaning as the "film". In addition, the electromagnetic wave shielding material can be a three-dimensionally formed article obtained by three-dimensionally forming a sheet-shaped electromagnetic wave shielding material, or it can also be a sheet-shaped electromagnetic wave shielding material for three-dimensional forming. As a three-dimensional forming method, it is possible to use various forming methods such as mold press forming, vacuum forming, and air pressure forming. Regarding the forming method, the forming that is carried out without heating a forming target and/or a mold or carried out by heating a forming target and/or a mold without raising the temperature too much is generally called cold forming. In one form, the electromagnetic wave shielding material can be formed by cold forming such as draw forming or bulge forming. The draw forming is a forming method in which a sheet-shaped forming target is pressed using a pair of molds of a female die and a male die, thereby being formed into bottomed containers having various shapes such as a cylinder, a square cylinder, and a conical shape. In contrast, a method of forming a formed article having a shape in which a curved surface protrudes from a flat surface, from a sheet-shaped forming target is bulge forming. The bulge forming can be carried out by pressing with only a male die without a female die. The draw forming is roughly classified into deep draw forming and shallow draw forming. A formed article having a shallow depth is formed by the shallow draw forming, and a formed article having a deep depth (for example, having a depth that is deeper than a diameter of a cylinder or a cone, or a length of one side of a pyramid) is formed by the deep draw forming. Known techniques can be applied to the three-dimensional forming method.

In one aspect of the present invention relates to an electromagnetic wave shielding material comprising a magnetic layer that contains a urethane resin and a resin having a partial structure represented by Formula 1 described above; and an electromagnetic wave shielding material comprising a magnetic layer that contains a urethane resin and a resin having one or more partial structures selected from the group consisting of Formula 1-1, Formula 1-2, Formula 1-3 described above.

The electromagnetic wave shielding material according to the above-described aspect can be an electromagnetic wave shielding material consisting of only the magnetic layer.

In addition, the electromagnetic wave shielding material according to the above-described aspect can be an electromagnetic wave shielding material having the magnetic layer between two resin-containing layers. In this case, each of the two resin-containing layers can be, for example, a layer adjacent to the magnetic layer. In addition, the two resin-containing layers can be, for example, the resin layer described above.

### [Electronic component]

One aspect of the present invention relates to an electronic component including the electromagnetic wave shielding material. Examples of the electronic component include an electronic component included in an electronic apparatus such as a mobile phone, a mobile information terminal, and a medical device, and various electronic components such as a semiconductor element, a capacitor, a coil, and a cable. The electromagnetic wave shielding material is three-dimensionally formed into any shape, for example, according to the shape of the electronic component, thereby capable of being disposed in the inside of the electronic component, or it is three-dimensionally formed into a shape of a cover material, thereby capable of being disposed as a cover material that covers the outside of the electronic component. Alternatively, it can be three-dimensionally formed into a tubular shape, thereby being disposed as a cover material that covers the outside of the cable.

### [Electronic apparatus]

One aspect of the present invention relates to an electronic apparatus including the electromagnetic wave shielding material. Examples of the electronic apparatus include electronic apparatuses such as a mobile phone, a mobile information terminal, and a medical device, electronic apparatuses including various electronic components such as a semiconductor element, a capacitor, a coil, and a cable, and electronic apparatuses in which electronic components are mounted on a circuit board. Such an electronic apparatus can include the electromagnetic wave shielding material as a constitutional member of an electronic component included in the device. In addition, as a constitutional member of the electronic apparatus, the electromagnetic wave shielding material can be disposed in the inside of the electronic apparatus or can be disposed as a cover material that covers the outside of the electronic apparatus. Alternatively, it can be three-dimensionally formed into a tubular shape, thereby being disposed as a cover material that covers the outside of the cable.

### Examples

Hereinafter, the present invention will be described in more detail with reference to Examples. However, the present invention is not limited to the embodiments shown in Examples.

### [Example 1]

### <Production of resin-containing layer>

### (Preparation of adhesive liquid)

To a plastic bottle, the following substances were added and mixed with a shaking type stirrer for 1 hour to prepare an adhesive liquid;
32.5% by mass of main agent (TM-250HV manufactured by Toyo-Morton, Ltd.),
4.5% by mass of curing agent (CAT-RT86L-60 manufactured by Toyo-Morton, Ltd.), and
63% by mass of ethyl acetate.

### (Application of adhesive)

One surface of a flame-retardant PET film (DIALAMY FR-02 manufactured by Mitsubishi Chemical Corporation) that achieved VTM-0 in the UL 94 VTM test was coated with the adhesive liquid using a blade coater having a coating gap of 50 µm, dried in a draft chamber for 30 minutes, and then dried in a drying device having an internal atmospheric temperature of 100°C for 1 minute.

In this way, a resin-containing layer having a laminated structure of a resin layer (flame-retardant PET film) and an adhesive layer was produced.

### <Production of metal layer with resin-containing layer>

Two resin-containing layers were produced according to the above method.

A metal layer (aluminum foil, model No. A1N30-O, manufactured by Takeuchi Metal Foil & Powder Co., Ltd.) was placed on the resin-containing layer with the adhesive layer facing upward, another resin-containing layer was superposed thereon with its adhesive layer facing the metal layer side, and the resulting "resin-containing layer/metal layer/resin-containing layer" laminate was sandwiched between two Teflon (registered trademark) sheets. Upper and lower press plates of a plate-shape pressing machine (Mini Test Press, manufactured by Toyo Seiki Seisaku-sho, Ltd.) were heated to 140°C (internal temperature of press plate), and the above-described laminate was held in a state of being applied with a pressure of 30 N/mm² for 10 minutes. The upper and lower press plates were cooled to 50°C (the internal temperature of the press plates) while maintaining the pressure, and then the metal layer with the resin-containing layer (laminate having a layer configuration of "resin-containing layer/metal layer/resin-containing layer") was taken out from between the two Teflon (registered trademark) sheets.

### <Preparation of composition for forming magnetic layer (coating liquid)>

To a plastic bottle, the following substances were added and mixed with a shaking type stirrer for 96 hours to prepare a coating liquid (composition for forming a magnetic layer);
Fe-Si-Al flat-shaped magnetic particles (Sendust MFS-SUH manufactured by MKT): 100 g,
Acrylic resin (acrylic rubber manufactured by Zeon Corporation under the trade name Nipol (model No. AR71)): 24.5 g,
Crosslinking agent (silane coupling agent (trade name: KBM-903) manufactured by Shin-Etsu Silicone Co., Ltd.): 0.5 g, and
Methyl ethyl ketone: 294g.

### <Production of magnetic layer>

### (Formation of film of magnetic layer)

The coating liquid was applied onto the surface of one resin-containing layer of the metal layer with a resin-containing layer using a blade coater having a coating gap of 380 µm and dried in a drying device having an internal atmospheric temperature of 90°C for 8 minutes to form a film of a magnetic layer.

### <Production of electromagnetic wave shielding material>

Using the above-described method, two metal layers with a resin-containing layer (laminate having a layer configuration of "resin-containing layer/metal layer/resin-containing layer/magnetic layer") in which a magnetic layer was formed into a film were produced.

The two metal layers with a resin-containing layer were superposed with the magnetic layers facing each other, and were sandwiched between two Teflon (registered trademark) sheets. Upper and lower press plates of a plate-shape pressing machine (Mini Test Press, manufactured by Toyo Seiki Seisaku-sho, Ltd.) were heated to 140°C (internal temperature of press plate), and the above-described laminate was held in a state of being applied with a pressure of 3 N/mm² for 10 minutes. The upper and lower press plates were cooled to 50°C (the internal temperature of the press plates) while maintaining the pressure, and then the electromagnetic wave shielding material was taken out from between the two Teflon (registered trademark) sheets.

In the tables below, the flame-retardant PET film is described as "Flame-retardant PET", and the aluminum foil is described as "Aluminum".

### <Measurement of thickness of each layer>

Cross-section processing was carried out to expose the cross-section of the electromagnetic wave shielding material by the following method.

A shielding material cut out to a size of 3 mm × 3 mm was embedded in a resin, and a cross section of the electromagnetic wave shielding material was cut out with an ion milling device (IM4000PLUS manufactured by Hitachi High-Tech Corporation). The cross-section of the electromagnetic wave shielding material, which had been exposed in this way, was observed with a scanning electron microscope (SU8220, manufactured by Hitachi High-Tech Corporation) under the conditions of an acceleration voltage of 2 kV and a magnification of 100 times to obtain a backscattered electron image. From the obtained image, the thicknesses of each layer were measured at five randomly selected points based on the scale bar, and the arithmetic averages of the respective thicknesses were denoted as the thickness of each layer.

In the tables below, the thickness of each layer is shown in parentheses in each column of "Layer configuration" and "Details of layer configuration".

### <Heat shock test>

The following test was performed according to the JIS C 60068-2-14:2011 test Na standard.

The electromagnetic wave shielding material was cut out to a size of 15 cm × 15 cm, installed in an air-to-air heat shock test apparatus (TSA-203ES-W manufactured by ESPEC CORP), and stored in a temperature environment subjected to 5 cycles consisting of 3 hours at -40°C on the low temperature side, 3 hours at +125°C on the high temperature side, and a temperature recovery time of 18 minutes or less. The electromagnetic wave shielding material after storage was taken out from the apparatus, and the appearance was confirmed by visual inspection.

### (Evaluation standard)

A: no peeling was observed between layers and/or within a layer.
B: peeling was observed between layers and/or within a layer.

### <Salt spray test>

The test was performed under the following conditions according to the JIS Z 7227:1998 standard. The spray liquid was sprayed toward any one surface of the electromagnetic wave shielding material. After the test, the sample was washed with water and naturally dried, and then the appearance was observed by visual inspection.

### (Test conditions)

Spray liquid: 50 ± 5 g/L NaCl aqueous solution, pH 6.5 to 7.2
Spray amount: 1.5 ± 0.5 mL/h per 80 cm²
Test chamber temperature: 35 ± 2°C
Disposition angle: inclined by 20 degrees with respect to the vertical direction, test time: 168 hours

### (Evaluation standard)

A: no difference was observed in the appearance of the surface (hereinafter, "surface to be sprayed") sprayed with the spray liquid before and after the test.
B: a significant difference was observed in the appearance of the surface to be sprayed after the test compared to before the test.

### <Flammability test>

The following test was performed according to UL 94 V standard.

Five electromagnetic wave shielding materials cut out with a cutter knife to have a length of 125 mm and a width of 13 mm were prepared as test pieces. Each test piece was clamped and fixed vertically, and a burner with a flame size adjusted to 20 mm was applied to the end part for 10 seconds to observe the combustion state of the sample. The test results were classified according to the flammability classification shown in the following table, and evaluated according to the following evaluation standard. For Evaluation Result A, the flammability classification is shown in parentheses in the column of the flammability test in the table below.

### (Evaluation standard)

A: flammability classification is V-0 or V-1
B: flammability classification is V-2
C: combustion occurred up to clamp

**[Table 1]**

| Determination criteria | Flammability classification | | |
|---|---|---|---|
| | V-0 | V-1 | V-2 |
| Combustion time of each test piece | 10 seconds or less | More than 10 seconds 30 seconds or less | More than 10 seconds 30 seconds or less |
| Total combustion time of five materials | 50 seconds or less | More than 50 seconds 250 seconds or less | More than 50 seconds 250 seconds or less |
| Combustion and growing time of each test piece | 30 seconds or less | More than 30 seconds 60 seconds or less | More than 30 seconds 60 seconds or less |
| Combustion until growing | Absent | Absent | Absent |
| Cotton ignition by dripped material | Absent | Absent | Present |

### <Tensile test>

The following test was performed according to JIS K 7127:1999 standard.

Five samples obtained by punching the electromagnetic wave shielding material into a dumbbell shape of JIS K 7127 Type 5 were prepared, and fixed to a universal material testing instrument (68FM-300 manufactured by Instron) at a distance between chucks of 80 mm. The elongation was measured using a high-performance video extensometer (AVE2 manufactured by Instron) at a test environment of 23°C ± 2°C, a relative humidity of 50% ± 10%, a test speed of 50 mm/min, and a gauge length of 25 mm. The breaking strain was obtained from the elongation at breaking point in time. The evaluation was performed according to the following evaluation standard from the obtained value of breaking elongation.

### (Evaluation standard)

A: breaking elongation was 40% or more
B: breaking elongation was less than 40%

### [Example 2]

One resin-containing layer laminated on the metal layer was a resin-containing layer produced using a PET film (Lumirror #38-S10 manufactured by Toray Industries, Inc.) instead of a flame-retardant PET film (DIALAMY FR-02 manufactured by Mitsubishi Chemical Corporation), and a magnetic layer was formed into a film on the side of the resin-containing layer having the PET film (Lumirror #38-S10 manufactured by Toray Industries, Inc.).

An electromagnetic wave shielding material was produced and various evaluations were carried out according to the method described for Example 1, except for the above-described points.

In the tables below, "PET film" is described as "PET".

### [Example 3]

One resin-containing layer laminated on the metal layer was a resin-containing layer produced using a PET film (Lumirror #25-S10 manufactured by Toray Industries, Inc.) instead of a flame-retardant PET film (DIALAMY FR-02 manufactured by Mitsubishi Chemical Corporation), and a magnetic layer was formed into a film on the side of the resin-containing layer having the PET film (Lumirror #25-S10 manufactured by Toray Industries, Inc.).

An electromagnetic wave shielding material was produced and various evaluations were carried out according to the method described for Example 1, except for the above-described points.

### [Example 4]

Resin-containing layers laminated on both sides of the metal layer were a resin-containing layer produced using a PET film (Lumirror #25-S10 manufactured by Toray Industries, Inc.) instead of a flame-retardant PET film (DIALAMY FR-02 manufactured by Mitsubishi Chemical Corporation).

An electromagnetic wave shielding material was produced and various evaluations were carried out according to the method described for Example 1, except for the above-described points.

### [Example 5]

One resin-containing layer laminated on the metal layer was a resin-containing layer produced using a PET film (Lumirror #25-S10 manufactured by Toray Industries, Inc.) instead of a flame-retardant PET film (DIALAMY FR-02 manufactured by Mitsubishi Chemical Corporation).

The other resin-containing layer laminated on the metal layer was a resin-containing layer produced using a PET film (Lumirror #12-S10 manufactured by Toray Industries, Inc.) instead of a flame-retardant PET film (DIALAMY FR-02 manufactured by Mitsubishi Chemical Corporation), and a magnetic layer was formed into a film on the side of the resin-containing layer having the PET film (Lumirror #25-S10 manufactured by Toray Industries, Inc.).

An electromagnetic wave shielding material was produced and various evaluations were carried out according to the method described for Example 1, except for the above-described points.

### [Example 6]

One resin-containing layer laminated on the metal layer was a resin-containing layer produced using a PET film (Lumirror #25-S10 manufactured by Toray Industries, Inc.) instead of a flame-retardant PET film (DIALAMY FR-02 manufactured by Mitsubishi Chemical Corporation).

The other resin-containing layer laminated on the metal layer was a resin-containing layer produced using a PET film (Lumirror #12-S10 manufactured by Toray Industries, Inc.) instead of a flame-retardant PET film (DIALAMY FR-02 manufactured by Mitsubishi Chemical Corporation), and a magnetic layer was formed into a film on the side of the resin-containing layer having the PET film (Lumirror #12-S10 manufactured by Toray Industries, Inc.).

An electromagnetic wave shielding material was produced and various evaluations were carried out according to the method described for Example 1, except for the above-described points.

### [Example 7]

Resin-containing layers laminated on both sides of the metal layer were a resin-containing layer produced using a PET film (Lumirror #12-S10 manufactured by Toray Industries, Inc.) instead of a flame-retardant PET film (DIALAMY FR-02 manufactured by Mitsubishi Chemical Corporation).

An electromagnetic wave shielding material was produced and various evaluations were carried out according to the method described for Example 1, except for the above-described points.

### [Example 8]

A resin-containing layer laminated on one metal layer was a resin-containing layer produced using a PET film (Lumirror #12-S10 manufactured by Toray Industries, Inc.) instead of a flame-retardant PET film (DIALAMY FR-02 manufactured by Mitsubishi Chemical Corporation).

A resin-containing layer laminated on the other metal layer was a resin-containing layer produced using a PET film (Lumirror #25-S10 manufactured by Toray Industries, Inc.) instead of a flame-retardant PET film (DIALAMY FR-02 manufactured by Mitsubishi Chemical Corporation).

An electromagnetic wave shielding material was produced and various evaluations were carried out according to the method described for Example 1, except for the above-described points.

### [Example 9]

A resin-containing layer laminated on one metal layer was a resin-containing layer produced using a PET film (Lumirror #50-S10 manufactured by Toray Industries, Inc.) instead of a flame-retardant PET film (DIALAMY FR-02 manufactured by Mitsubishi Chemical Corporation). A magnetic layer was formed into a film on the surface of one resin-containing layer of the metal layer with a resin-containing layer (laminate having a layer configuration of "resin-containing layer/metal layer/resin-containing layer") produced as described above.

A magnetic layer was formed into a film directly on one surface of the other metal layer.

An electromagnetic wave shielding material was produced and various evaluations were carried out according to the method described for Example 1, except for the above-described points. The salt spray test was performed using the surface of the metal layer on the side where the resin-containing layer was not laminated as a surface to be sprayed.

### [Example 10]

A resin-containing layer laminated on one metal layer was a resin-containing layer produced using a PET film (Lumirror #25-S10 manufactured by Toray Industries, Inc.) instead of a flame-retardant PET film (DIALAMY FR-02 manufactured by Mitsubishi Chemical Corporation). A magnetic layer was formed into a film on the surface of one resin-containing layer of the metal layer with a resin-containing layer (laminate having a layer configuration of "resin-containing layer/metal layer/resin-containing layer") produced as described above.

A magnetic layer was formed into a film directly on one surface of the other metal layer.

An electromagnetic wave shielding material was produced and various evaluations were carried out according to the method described for Example 1, except for the above-described points. The salt spray test was performed using the surface of the metal layer on the side where the resin-containing layer was not laminated as a surface to be sprayed.

### [Example 11]

A resin-containing layer laminated on one metal layer was a resin-containing layer produced using a PET film (Lumirror #12-S10 manufactured by Toray Industries, Inc.) and a PET film (Lumirror #25-S10 manufactured by Toray Industries, Inc.) instead of a flame-retardant PET film (DIALAMY FR-02 manufactured by Mitsubishi Chemical Corporation). A magnetic layer was formed into a film on the surface of the PET film (Lumirror #25-S10 manufactured by Toray Industries, Inc.) of the metal layer with a resin-containing layer (laminate having a layer configuration of "resin-containing layer/metal layer/resin-containing layer") produced as described above.

A magnetic layer was formed into a film directly on one surface of the other metal layer.

An electromagnetic wave shielding material was produced and various evaluations were carried out according to the method described for Example 1, except for the above-described points. The salt spray test was performed using the surface of the metal layer on the side where the resin-containing layer was not laminated as a surface to be sprayed.

### [Example 12]

A resin-containing layer laminated on one metal layer was a resin-containing layer produced using a PET film (Lumirror #12-S10 manufactured by Toray Industries, Inc.) instead of a flame-retardant PET film (DIALAMY FR-02 manufactured by Mitsubishi Chemical Corporation). A magnetic layer was formed into a film on the surface of one resin-containing layer of the metal layer with a resin-containing layer (laminate having a layer configuration of "resin-containing layer/metal layer/resin-containing layer") produced as described above.

A magnetic layer was formed into a film directly on one surface of the other metal layer.

An electromagnetic wave shielding material was produced and various evaluations were carried out according to the method described for Example 1, except for the above-described points. The salt spray test was performed using the surface of the metal layer on the side where the resin-containing layer was not laminated as a surface to be sprayed.

### [Example 13]

### <Production of magnetic layer>

### (Formation of film of magnetic layer)

The coating liquid (composition for forming a magnetic layer) prepared according to the method described in Example 1 was applied onto a peeled surface of a peeling-treated PET film (PET75-LS2 manufactured by NIPPA Co., Ltd.) with a blade coater having a coating gap of 650 µm and dried for 8 minutes in a drying device having an internal atmospheric temperature of 90°C to form a film of a magnetic layer.

### (Pressurization treatment of magnetic layer)

Upper and lower press plates of a plate-shape pressing machine (Mini Test Press, manufactured by Toyo Seiki Seisaku-sho, Ltd.) were heated to 140°C (internal temperature of press plate), and a magnetic layer obtained by peeling off the peeling-treated PET film was sandwiched between two sheets of Teflon (registered trademark) having a thickness of 1 mm and held for 10 minutes in a state where a pressure of 3 N/mm² was applied. The upper and lower press plates were cooled to 50°C (the internal temperature of the press plates) while maintaining the pressure, and then the magnetic layer was taken out from between the two Teflon (registered trademark) sheets.

### <Production of electromagnetic wave shielding material>

The magnetic layer and a metal layer (aluminum foil, model No. A1N30-O, manufactured by Takeuchi Metal Foil & Powder Co., Ltd.) were bonded to each other using a double-sided tape (NeoFix 5S2, manufactured by NEION Film Coatings Corp.). In this way, two laminates having a layer configuration of "magnetic layer/double-sided tape/metal layer" were produced.

Separately, a double-sided tape (NeoFix 5S2, manufactured by NEION Film Coatings Corp.) was bonded to upper and lower surfaces of the magnetic layer to produce one laminate having a layer configuration of "double-sided tape/magnetic layer/double-sided tape".

A laminate having a layer configuration of "magnetic layer/double-sided tape/metal layer" was bonded to both sides of the laminate having a layer configuration of "double-sided tape/magnetic layer/double-sided tape" with the metal layer facing inward.

The electromagnetic wave shielding material produced in this way was evaluated according to the method described for Example 1.

In the tables below, "double-sided tape (NeoFix 5S2, manufactured by NEION Film Coatings Corp.)" is described as "NeoFix 5S".

### [Comparative Example 1]

A resin-containing layer produced using a PET film (Lumirror #12-S10 manufactured by Toray Industries, Inc.) instead of a flame-retardant PET film (DIALAMY FR-02 manufactured by Mitsubishi Chemical Corporation) is laminated on only one surface of the metal layer to form a magnetic layer into a film on the resin-containing layer side.

An electromagnetic wave shielding material was produced and various evaluations were carried out according to the method described for Example 1, except for the above-described points. After the heat shock test, peeling was observed at the interface between the magnetic layer and the adjacent layer.

### [Comparative Example 2]

A resin-containing layer produced using a PET film (Lumirror #25-S10 manufactured by Toray Industries, Inc.) instead of a flame-retardant PET film (DIALAMY FR-02 manufactured by Mitsubishi Chemical Corporation) is laminated on only one surface of the metal layer to form a magnetic layer into a film on the resin-containing layer side.

An electromagnetic wave shielding material was produced and various evaluations were carried out according to the method described for Example 1, except for the above-described points. After the heat shock test, peeling was observed at the interface between the magnetic layer and the adjacent layer.

### [Comparative Example 3]

A resin-containing layer produced using a PET film (Lumirror #50-S10 manufactured by Toray Industries, Inc.) instead of a flame-retardant PET film (DIALAMY FR-02 manufactured by Mitsubishi Chemical Corporation) is laminated on only one surface of the metal layer to form a magnetic layer into a film on the resin-containing layer side.

An electromagnetic wave shielding material was produced and various evaluations were carried out according to the method described for Example 1, except for the above-described points. After the heat shock test, peeling was observed at the interface between the magnetic layer and the adjacent layer.

### [Comparative Example 4]

One resin-containing layer laminated on the metal layer was a resin-containing layer produced using a PET film (Lumirror #50-S10 manufactured by Toray Industries, Inc.) instead of a flame-retardant PET film (DIALAMY FR-02 manufactured by Mitsubishi Chemical Corporation), and the other resin-containing layer was a resin-containing layer produced using a PET film (Lumirror #12-S10, manufactured by Toray Industries, Inc.) instead of a flame-retardant PET film (DIALAMY FR-02, manufactured by Mitsubishi Chemical Corporation). A magnetic layer was formed into a film on the side of the resin-containing layer having the PET film (Lumirror #12-S10, manufactured by Toray Industries, Inc.).

An electromagnetic wave shielding material was produced and various evaluations were carried out according to the method described for Example 1, except for the above-described points. After the heat shock test, peeling was observed at the interface between the magnetic layer and the adjacent layer.

### [Comparative Example 5]

One resin-containing layer laminated on the metal layer was a resin-containing layer produced using a PET film (Lumirror #50-S10 manufactured by Toray Industries, Inc.) instead of a flame-retardant PET film (DIALAMY FR-02 manufactured by Mitsubishi Chemical Corporation), and the other resin-containing layer was a resin-containing layer produced using a PET film (Lumirror #25-S10, manufactured by Toray Industries, Inc.) instead of a flame-retardant PET film (DIALAMY FR-02, manufactured by Mitsubishi Chemical Corporation). A magnetic layer was formed into a film on the side of the resin-containing layer having the PET film (Lumirror #25-S10, manufactured by Toray Industries, Inc.).

An electromagnetic wave shielding material was produced and various evaluations were carried out according to the method described for Example 1, except for the above-described points. After the heat shock test, peeling was observed at the interface between the magnetic layer and the adjacent layer.

### [Comparative Example 6]

A magnetic layer was produced by the method described for Example 13, and a double-sided tape (NeoFix 5S2, manufactured by NEION Film Coatings Corp.) was bonded to the upper and lower surfaces of the magnetic layer. Separately, two laminates each obtained by bonding a PET film (Lumirror #50-S10, manufactured by Toray Industries, Inc.) and a metal layer (aluminum foil, model No. A1N30-O, manufactured by Takeuchi Metal Foil & Powder Co., Ltd.) with a double-sided tape (NeoFix 5S2, manufactured by NEION Film Coatings Corp.) were prepared, and the metal layer was bonded to the magnetic layer side through the double-sided tape on the upper and lower surfaces of the magnetic layer.

The electromagnetic wave shielding material produced in this way was evaluated according to the method described for Example 1.

The layer configurations and the like of the electromagnetic wave shielding materials of Examples and Comparative Examples, and the various evaluation results are shown in the following tables.

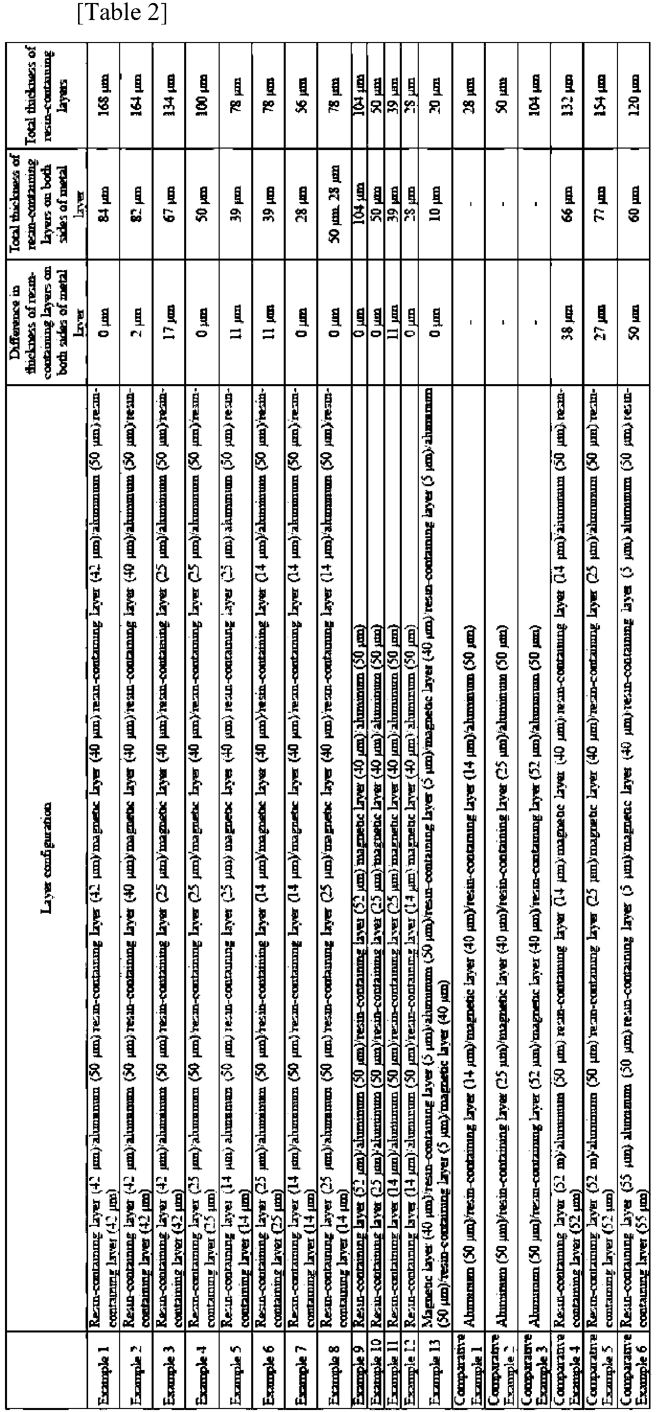

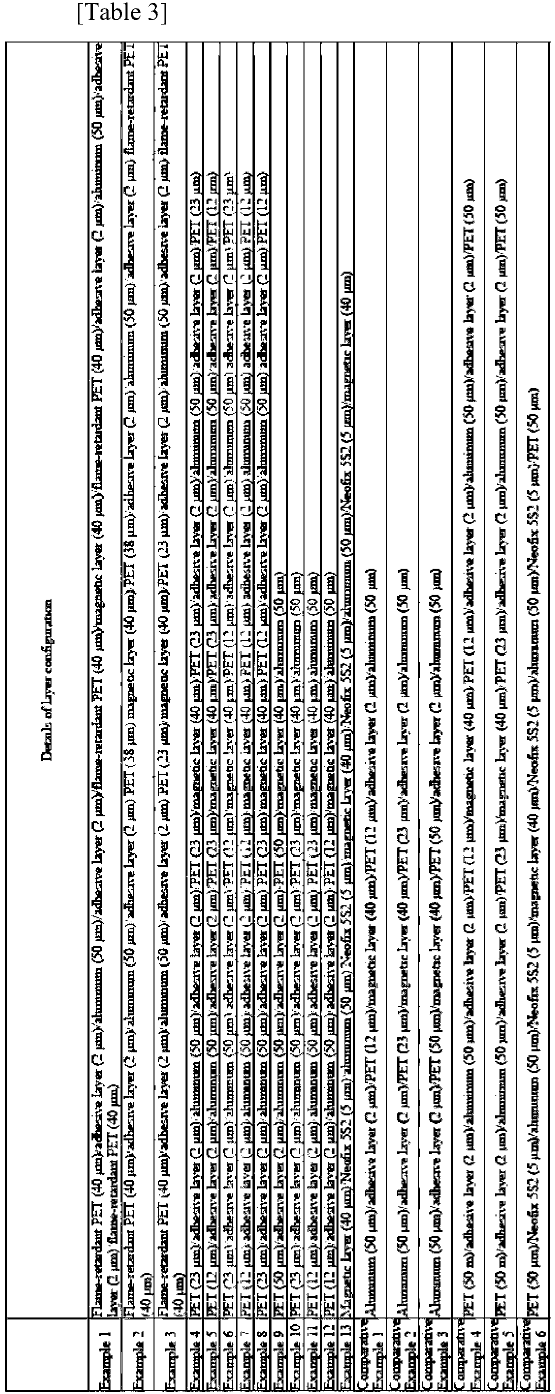

### [Example 14]

An electromagnetic wave shielding material was produced and various evaluations were carried out according to the method described for Example 1, except that a composition (coating liquid) for forming a magnetic layer was prepared as follows. The magnetic layer produced by using the following coating liquid contains a urethane resin and a resin having a partial structure represented by Formula 1.

### <Preparation of composition for forming magnetic layer (coating liquid)>

To a plastic bottle, the following substances were added and mixed with a shaking type stirrer for 1 hour;
Fe-Si-Al flat-shaped magnetic particles (Sendust (trade name MFS-SUH) manufactured by MKT): 100 g,
Urethane resin (urethane resin solution ((trade name NIPPOLLAN 5120), manufactured by Tosoh Corporation): 53.9 g,
Epoxy resin (modified epoxy resin (trade name HP-A-4860) manufactured by DIC Corporation): 6.2 g, and
Cyclohexanone: 183.2 g.
After mixing, the following substances were added and mixed with a shaking type stirrer for 10 minutes to prepare a coating liquid (composition for forming a magnetic layer);
Curing agent (adduct of TDI and polyol compound (trade name TAKENATE D101E, manufactured by Mitsui Chemicals Inc.)): 2.4 g, and
Curing accelerator (1-Isobutyl-2-methylimidazole (trade name IBMI12) manufactured by Mitsubishi Chemical Corporation): 0.2 g.

### [Example 15]

An electromagnetic wave shielding material was produced and various evaluations were carried out according to the method described for Example 1, except that a composition (coating liquid) for forming a magnetic layer was prepared as follows. The magnetic layer produced by using the following coating liquid contains a urethane resin and a resin having a partial structure represented by Formula 1-1.

### <Preparation of composition for forming magnetic layer (coating liquid)>

To a plastic bottle, the following substances were added and mixed with a shaking type stirrer for 1 hour;
Fe-Si-Al flat-shaped magnetic particles (Sendust (trade name MFS-SUH) manufactured by MKT): 100 g,
Urethane resin (urethane resin solution ((trade name NIPPOLLAN 5120), manufactured by Tosoh Corporation): 53.9 g,
Epoxy resin (modified epoxy resin (trade name HP-A-4860) manufactured by DIC Corporation): 6.2 g, and
Cyclohexanone: 183.2 g.
After mixing, the following substances were added and mixed with a shaking type stirrer for 10 minutes to prepare a coating liquid (composition for forming a magnetic layer);
Curing agent (HDI (hexamethylene diisocyanate) (trade name DURANATE TPA-100, manufactured by Asahi Kasei Co., Ltd.)): 2.4 g, and
Curing accelerator (1-Isobutyl-2-methylimidazole (trade name IBMI12) manufactured by Mitsubishi Chemical Corporation): 0.2 g.

The various evaluation results of the electromagnetic wave shielding materials of Examples 1 to 15 and Comparative Examples 1 to 6 are shown in the following tables.

**[Table 4]**

| | Heat shock test | Salt spray test | Tensile test | Flammability test |
|---|---|---|---|---|
| Example 1 | A | A | A | A (V-0) |
| Example 2 | A | A | A | A (V-0) |
| Example 3 | A | A | A | A (V-0) |
| Example 4 | A | A | A | C |
| Example 5 | A | A | A | A (V-1) |
| Example 6 | A | A | A | A (V-1) |
| Example 7 | A | A | B | A (V-1) |
| Example 8 | A | A | B | A (V-1) |
| Example 9 | A | B | B | C |
| Example 10 | A | B | B | A (V-1) |
| Example 11 | A | B | B | A (V-1) |
| Example 12 | A | B | B | A (V-1) |
| Example 13 | A | B | B | A (V-1) |
| Example 14 | A | A | A | A (V-0) |
| Example 15 | A | A | A | A (V-0) |
| Comparative Example 1 | B | B | B | A(V-1) |
| Comparative Example 2 | B | B | B | A(V-1) |
| Comparative Example 3 | B | B | A | C |
| Comparative Example 4 | B | A | A | C |
| Comparative Example 5 | B | A | A | C |
| Comparative Example 6 | B | A | A | C |

### [Test of strength of magnetic layer]

### <Production of magnetic layer sample for strength test>

### (Formation of film of magnetic layer)

The coating liquid (composition for forming a magnetic layer) prepared according to the method described in Example 1 was applied onto a peeled surface of a peeling-treated PET film (trade name PET75×1-JOL manufactured by NIPPA Co., Ltd.) with a blade coater having a coating gap of 450 µm and dried for 8 minutes in a drying device having an internal atmospheric temperature of 90°C to form a film of a magnetic layer.

### (Pressurization of magnetic layer for strength test)

The magnetic layer formed into a film by the above-described method was peeled off from the peeling-treated PET film, and placed on a peeled surface side of another peeling-treated PET film (trade name, PET100×1-LS2, manufactured by NIPPA Co., Ltd.), and another peeling-treated PET film (trade name, PET100×1-LS2, manufactured by NIPPA Co., Ltd.) was superposed on the magnetic layer with the peeled surface facing the magnetic layer side. The laminate having a layer configuration of "peeling-treated PET film/magnetic layer/peeling-treated PET film" produced in this way was sandwiched between two Teflon (registered trademark) sheets. Upper and lower press plates of a plate-shape pressing machine (Mini Test Press, manufactured by Toyo Seiki Seisaku-sho, Ltd.) were heated to 140°C (internal temperature of press plate), and the above-described laminate was held in a state of being applied with a pressure of 3 N/mm² for 10 minutes. The upper and lower press plates were cooled to 50°C (the internal temperature of the press plates) while maintaining the pressure, and then the magnetic layer was taken out from between the two Teflon (registered trademark) sheets and the peeling-treated PET film.

### (Cutting out of magnetic layer sample for strength test)

The magnetic layer taken out above was cut out into a strip shape having a length of 40 mm and a width of 10 mm with a cutter to obtain a magnetic layer sample for a strength test (Reference Sample 1-1).

A magnetic layer sample for a strength test (Reference Sample 1-14) was produced by the method described for Reference Sample 1-1, except that the coating liquid (composition for forming a magnetic layer) prepared by the method described for Example 14 was used.

A magnetic layer sample for a strength test (Reference Sample 1-15) was produced by the method described for Reference Sample 1-1, except that the coating liquid (composition for forming a magnetic layer) prepared by the method described for Example 15 was used.

### <Measurement of strength of magnetic layer>

The strength of each sample of Reference Sample 1-1, Reference Sample 1-14, and Reference Sample 1-15 was measured by the following method.

The test environment was set to a temperature of 23°C ± 2°C and a relative humidity of 50% ± 10%, a force measurement stand (trade name MX-2-500N) manufactured by IMADA Co., Ltd. was attached with a digital force gauge (trade name ZTS-100N) manufactured by IMADA Co., Ltd., and a film chuck (trade name FC-21) manufactured by IMADA Co., Ltd. was attached to the force measurement stand and the digital force gauge. The distance between the tip portions of the two film chucks was set to 20 mm, both ends of the sample were clamped by 10 mm each in the film chuck in a direction in which the long side of the sample was parallel to the tensile direction, and the sample was attached.

The rising speed of the force measurement stand was set to 10 mm/min, the rising button of the force measurement stand was continuously pressed until the sample was fractured, and the stress [N] at that time was recorded in a personal computer (PC) connected to the digital force gauge. The tensile strength [MPa] was obtained by the following equation from the measured stress [N], the width of the sample of 10 mm, and the thickness [µm] of the sample. $Tensile strength \left[MPa\right] = - stress \left[N\right] / \left(10 \left[mm\right]\times thickness \left[μm\right] of sample/1000\right)$

The maximum value of the tensile strength obtained for each sample is shown in the following table as the strength of the sample.

**[Table 5]**

| | Strength |
|---|---|
| Reference Sample 1-1 | 10 MPa |
| Reference Sample 1-14 | 25 MPa |
| Reference Sample 1-15 | 33 MPa |

### [Peel strength test]

### <Production of laminate sample for peel strength test>

The magnetic layer formed into a film on the peeling-treated PET film by the method described above for Reference Sample 1-1 was peeled off from the peeling-treated PET film, placed on a PET film (Lumirror #100-S10 manufactured by Toray Industries, Inc.), and another PET film (Lumirror #100-S10 manufactured by Toray Industries, Inc.) was superposed on the magnetic layer. The laminate having a layer configuration of "PET film/magnetic layer/PET film" was sandwiched between two Teflon (registered trademark) sheets. Upper and lower press plates of a plate-shape pressing machine (Mini Test Press, manufactured by Toyo Seiki Seisaku-sho, Ltd.) were heated to 140°C (internal temperature of press plate), and the above-described laminate was held in a state of being applied with a pressure of 3 N/mm² for 10 minutes. The upper and lower press plates were cooled to 50°C (the internal temperature of the press plates) while maintaining the pressure, and then the laminate having a layer configuration of "PET film/magnetic layer/PET film") was taken out from between the two Teflon (registered trademark) sheets. The laminate was used as a sample for a peel strength test (Reference Sample 2-1).

A sample for a peel strength test (Reference Sample 2-14) was produced by the method described for Reference Sample 2-1, except that the coating liquid (composition for forming a magnetic layer) prepared by the method described for Example 14 was used.

A sample for a peel strength test (Reference Sample 2-15) was produced by the method described for Reference Sample 2-1, except that the coating liquid (composition for forming a magnetic layer) prepared by the method described for Example 15 was used.

### <Measurement of peel strength>

The peel strength of each sample of Reference Sample 2-1, Reference Sample 2-14, and Reference Sample 2-15 was measured by the following method. It can be said that the larger the measured value of the peel strength, the higher the adhesiveness between the magnetic layer and the layer adjacent to the magnetic layer.

A double-sided tape No. 5015 (manufactured by Nitto Denko Corporation), from which a release tape on one side had been peeled, was attached at the center in the width direction of the stainless steel plate having a length of 120 mm, a width of 40 mm, and a thickness of 2 mm, to extend in the length direction of the stainless steel plate, and a soft urethane roller N010840 (manufactured by Ota Seisakusho) was reciprocated 10 times from the release film on the other side while applying a force to fix the double-sided tape. The release film on the surface of the double-sided tape was peeled off, a sample cut out to a width of 10 mm and a length of 100 mm was placed thereon, and a soft urethane roller N010840 (manufactured by Ota Seisakusho) was reciprocated 10 times while applying a force to fix the sample. After being left in the room temperature air for 48 hours, the sample (laminate) was inserted into the position of the magnetic layer, and a peel portion having a length of 10 mm was provided. The sample was attached to a standard stage of a peel tester VPA-H100F (manufactured by Kyowa Interface Science Co., Ltd.) together with the stainless steel plate. A polyimide film 200H (manufactured by Du Pont-Toray Co., Ltd.) having a thickness of 50 µm was cut out to a length of 100 mm and a width of 10, and one end of the polyimide film and the peel portion of the shielding material were adhered to each other through a double-sided tape No. 5015 (manufactured by Nitto Denko Corporation) cut to a length of 10 mm. The other end of the polyimide film was attached to a gripping part of a measuring unit of the peel tester, and a peel force [N/cm] was measured under conditions of a peeling angle of 90°, a peeling rate of 20 mm/min, and a measurement distance of 60 mm. An average value (arithmetic average) of the measurement results at a measurement distance of 20 mm to 50 mm was defined as the peel strength of the sample.

Each sample was evaluated according to the following evaluation standard from the obtained value of peel strength. The evaluation results are shown in the tables below.

### (Evaluation standard)

A: peel strength was 3 N/mm or more.
B: peel strength was 1 N/mm or more and less than 3 N/mm.
C: peel strength was less than 1 N/mm.

**[Table 6]**

| | Peel strength test |
|---|---|
| Reference Sample 2-1 | C |
| Reference Sample 2-14 | B |
| Reference Sample 2-15 | A |

The above-described sample was subjected to a peel strength test by the above-described method instead of the shielding material of Example 1, Example 14, or Example 15. The evaluation was performed according to the above-described evaluation standard from the obtained value of peel strength. The evaluation results are shown in the tables below.

**[Table 7]**

| | Peel strength test |
|---|---|
| Example 1 | C |
| Example 14 | B |
| Example 15 | A |

### Industrial Applicability

One aspect of the present invention is useful in the technical fields of various electronic components and various electronic apparatuses.

## Claims

1. An electromagnetic wave shielding material comprising:
one or more magnetic layers sandwiched between two metal layers; and
resin-containing layers on both sides of at least one metal layer of the two metal layers,
wherein a difference in thickness between the resin-containing layers on both sides of the metal layer is 20 µm or less.

2. The electromagnetic wave shielding material according to claim 1,
wherein a total thickness of the resin-containing layers on both sides of the metal layer is 30 µm or more.

3. The electromagnetic wave shielding material according to claim 1,
wherein a total thickness of the resin-containing layers included in the electromagnetic wave shielding material is less than 100 µm.

4. The electromagnetic wave shielding material according to claim 1,
wherein at least one resin-containing layer of the resin-containing layers on both sides of the metal layer includes one or more flame-retardant layers.

5. The electromagnetic wave shielding material according to claim 2,
wherein the total thickness of the resin-containing layers included in the electromagnetic wave shielding material is less than 100 µm, and
at least one resin-containing layer of the resin-containing layers on both sides of the metal layer includes one or more flame-retardant layers.

6. The electromagnetic wave shielding material according to claim 1,
wherein resin-containing layers are provided on both sides of each of the two metal layers.

7. The electromagnetic wave shielding material according to claim 6,
wherein a difference in thickness of the resin-containing layers located on both sides of one metal layer of the two metal layers is 20 µm or less, and a difference in thickness of the resin-containing layers located on both sides of the other metal layer is 20 µm or less.

8. The electromagnetic wave shielding material according to claim 6,
wherein a total thickness of the resin-containing layers located on both sides of one metal layer of the two metal layers is 30 µm or more, and a total thickness of the resin-containing layers located on both sides of the other metal layer is 30 µm or more.

9. The electromagnetic wave shielding material according to claim 6,
wherein a total thickness of the resin-containing layers included in the electromagnetic wave shielding material is less than 100 µm.

10. The electromagnetic wave shielding material according to claim 6,
wherein at least one of the resin-containing layers includes one or more flame-retardant layers.

11. The electromagnetic wave shielding material according to claim 7,
wherein a total thickness of the resin-containing layers located on both sides of one metal layer of the two metal layers is 30 µm or more, and a total thickness of the resin-containing layers located on both sides of the other metal layer is 30 µm or more,
a total thickness of the resin-containing layers included in the electromagnetic wave shielding material is less than 100 µm, and at least one of the resin-containing layers includes one or more flame-retardant layers.

12. The electromagnetic wave shielding material according to claim 1,
wherein the magnetic layer contains
a urethane resin, and
a resin having a partial structure represented by Formula 1: 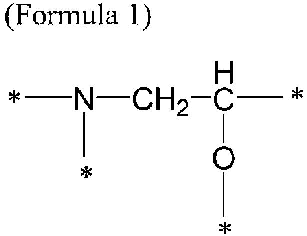 (in Formula 1, * represents a bonding position to an adjacent atom).

13. The electromagnetic wave shielding material according to claim 1,
wherein the magnetic layer contains
a urethane resin, and
a resin having one or more partial structures selected from the group consisting of a partial structure represented by Formula 1-1, a partial structure represented by Formula 1-2, and a partial structure represented by Formula 1-3: 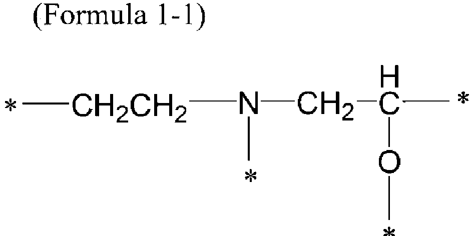 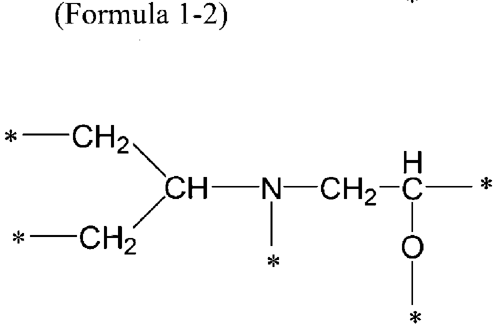 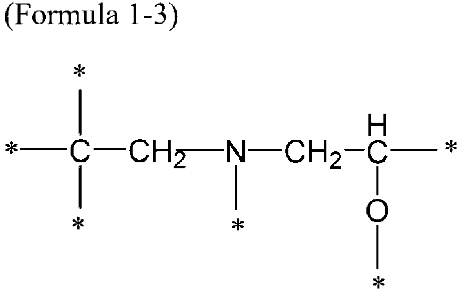 (in Formula 1-1, Formula 1-2, and Formula 1-3, * represents a bonding position to an adjacent atom).

14. An electronic component comprising:
the electromagnetic wave shielding material according to any one of claims 1 to 13.

15. An electronic apparatus comprising:
the electromagnetic wave shielding material according to any one of claims 1 to 13.
